# EUROPEAN PATENT APPLICATION

(11) **EP 4 593 551 A1**
(43) Date of publication of application: **30.07.2025**
(21) Application number: 24196946.8
(22) Date of filing: 28.08.2024
(51) Int. Cl.: H10D 30/01, H10D 30/00, H10D 64/01, H10D 84/85, H10D 62/17, B82Y 10/00

(54) **SEMICONDUCTOR DEVICE**

(30) Priority: 23.01.2024 KR 20240010060; 19.03.2024 KR 20240037682
(71) Applicant: Samsung Electronics Co., Ltd., Gyeonggi-do, 16677 (KR)
(72) Inventor: YU, Hyun-Kwan, Suwon-si, Gyeonggi-do 16677 (KR); JUNG, Yeon Do, Suwon-si, Gyeonggi-do 16677 (KR); SHIN, Dong Suk, Suwon-si, Gyeonggi-do 16677 (KR)
(74) Representative: Kuhnen & Wacker Patent- und Rechtsanwaltsbüro PartG mbB

(57) **Abstract**

A semiconductor device includes a first active pattern including a first lower pattern and first sheet patterns spaced apart from the first lower pattern in a first direction, a first gate structure including first inner gates between the first lower pattern and a lowermost first sheet pattern of the first sheet patterns, and between each pair of adj acent first sheet patterns, the first inner gates extending in a second direction that intersects the first direction, where each of the first inner gates includes a first gate electrode and a first gate insulating film, first source/drain patterns on the first lower pattern and connected to the first sheet patterns, first inner spacers between the first source/drain patterns and the first inner gates, and first nitrogen build-up areas within the first inner spacers.

## Description

### BACKGROUND

Example embodiments of the disclosure relate to a semiconductor device.

As one of the scaling technologies to increase the density of semiconductor devices, multi-gate transistors have been proposed. The multi-gate transistors may be produced by forming multi-channel active patterns (or silicon bodies) in the shape of fins or nanowires on a substrate and then forming gates on the surfaces of the multi-channel active patterns.

The multi-gate transistors may be easier to scale due to the utilization of three-dimensional (3D) channels. Additionally, the multi-gate transistors may improve current control capabilities without increasing their gate length. Moreover, the multi-gate transistors may effectively suppress the short channel effect (SCE), where the potential in a channel area is affected by the drain voltage.

As the pitch size of semiconductor devices decreases, reduction of parasitic capacitance is needed to ensure electrical stability between contacts within a semiconductor device.

Information disclosed in this Background section has already been known to or derived by the inventors before or during the process of achieving the embodiments of the present application, or is technical information acquired in the process of achieving the embodiments. Therefore, it may contain information that does not form the prior art that is already known to the public.

### SUMMARY

One or more example embodiments provide a semiconductor device that can improve device performance and reliability.

Additional aspects will be set forth in part in the description which follows and, in part, will be apparent from the description, or may be learned by practice of the presented embodiments.

According to an aspect of an example embodiment, a semiconductor device may include a first active pattern including a first lower pattern and first sheet patterns spaced apart from the first lower pattern in a first direction, a first gate structure including first inner gates between the first lower pattern and a lowermost first sheet pattern of the first sheet patterns, and between each pair of adjacent first sheet patterns, the first inner gates extending in a second direction that intersects the first direction, where each of the first inner gates includes a first gate electrode and a first gate insulating film, first source/drain patterns on the first lower pattern and connected to the first sheet patterns, first inner spacers between the first source/drain patterns and the first inner gates, and first nitrogen build-up areas within the first inner spacers, where each of the first inner gates may have a first surface, a second surface opposite to the first surface in the first direction, and sidewalls connecting the first surface and the second surface, and the first nitrogen build-up areas may extend along the sidewalls of the first inner gates.

According to an aspect of an example embodiment, a semiconductor device may include a first active pattern including a first lower pattern and first sheet patterns spaced apart from the first lower pattern in a first direction, a first gate structure including first inner gates between the first lower pattern and a lowermost first sheet pattern of the first sheet patterns, and between each pair of adjacent first sheet patterns, the first inner gates extending in a second direction that intersects the first direction, where each of the first inner gates includes a first gate electrode and a first gate insulating film, first source/drain patterns on the first lower pattern, including doped n-type impurities, and connected to the first sheet patterns, first inner spacers between the first source/drain patterns and the first inner gates, and first nitrogen build-up areas extending along boundaries between the first source/drain patterns and the first inner spacers, and along boundaries between the first inner gates and the first sheet patterns.

According to an aspect of an example embodiment, a semiconductor device may include a first active pattern including a first lower pattern and first sheet patterns spaced apart from the first lower pattern in a first direction, a first gate structure including first inner gates between the first lower pattern and a lowermost first sheet pattern of the first sheet patterns, and between each pair of adjacent first sheet patterns, the first inner gates extending in a second direction that intersects the first direction, where each of the first inner gates includes a first gate electrode and a first gate insulating film, first source/drain patterns on the first lower pattern and connected to the first sheet patterns, first inner spacers between the first source/drain patterns and the first inner gates, a second active pattern including a second lower pattern and second sheet patterns spaced apart from the second lower pattern in the first direction, a second gate structure including second inner gates between the second lower pattern and a lowermost second sheet pattern of the second sheet patterns, and between each pair of adjacent second sheet patterns, the second inner gates extending in the second direction, second source/drain patterns on the second lower pattern and connected to the second sheet patterns, second inner spacers between the second source/drain patterns and the second inner gates, first nitrogen build-up areas within the first inner spacers, and second nitrogen build-up areas within the second inner spacers, where, in a third direction that intersects the first direction and the second direction a length of at least one of the first sheet patterns having a first height is greater than a length of at least one of the second sheet patterns having the first height.

However, aspects of the present disclosure are not restricted to those set forth herein. The above and other aspects of the present disclosure will become more apparent to one of ordinary skill in the art to which the present disclosure pertains by referencing the detailed description of the present disclosure given below.

### BRIEF DESCRIPTION OF DRAWINGS

The above and other aspects, features, and advantages of certain example embodiments of the present disclosure will be more apparent from the following description taken in conjunction with the accompanying drawings, in which:
FIG. 1 is a diagram illustrating a semiconductor device according to one or more embodiments;
FIG. 2 is a cross-sectional view taken along line A-A of FIG. 1 according to one or more embodiments;
FIG. 3 is a cross-sectional view taken along line B-B of FIG. 1 according to one or more embodiments;
FIG. 4 is a cross-sectional view taken along line C-C of FIG. 1 according to one or more embodiments;
FIG. 5 is an enlarged cross-sectional view of portion P of FIG. 2 according to one or more embodiments;
FIG. 6 is an enlarged cross-sectional view of portion Q of FIG. 3 according to one or more embodiments;
FIG. 7 is a graph illustrating the concentration of nitrogen (N) along "SCAN LINE 1" and "SCAN LINE 2" of FIG. 5 according to one or more embodiments;
FIG. 8 is a diagram illustrating a semiconductor device according to one or more embodiments;
FIG. 9 is a graph illustrating the concentration of nitrogen (N) along "SCAN LINE 1" and "SCAN LINE 2" of FIG. 8 according to one or more embodiments;
FIGS. 10 and 11 are diagrams illustrating semiconductor devices according to one or more embodiments;
FIGS. 12 and 13 are diagrams illustrating semiconductor devices according to one or more embodiments;
FIG. 14 is a diagram illustrating a semiconductor device according to one or more embodiments;
FIG. 15 is a graph illustrating the concentration of nitrogen (N) along "SCAN LINE 1" and "SCAN LINE 2" of FIG. 14 according to one or more embodiments;
FIGS. 16 and 17 are diagrams illustrating a semiconductor device according to one or more embodiments;
FIGS. 18 and 19 are diagrams illustrating a semiconductor device according to one or more embodiments;
FIG. 20 is a diagram illustrating a semiconductor device according to one or more embodiments; and
FIGS. 21 through 39 are diagrams illustrating operations of a method of fabricating a semiconductor device according to one or more embodiments.

### DETAILED DESCRIPTION

Hereinafter, example embodiments of the disclosure will be described in detail with reference to the accompanying drawings. The same reference numerals are used for the same components in the drawings, and redundant descriptions thereof will be omitted. The embodiments described herein are example embodiments, and thus, the disclosure is not limited thereto and may be realized in various other forms.

As used herein, expressions such as "at least one of," when preceding a list of elements, modify the entire list of elements and do not modify the individual elements of the list. For example, the expression, "at least one of a, b, and c," should be understood as including only a, only b, only c, both a and b, both a and c, both b and c, or all of a, b, and c.

It will be understood that when an element or layer is referred to as being "over," "above," "on," "below," "under," "beneath," "connected to" or "coupled to" another element or layer, it can be directly over, above, on, below, under, beneath, connected or coupled to the other element or layer or intervening elements or layers may be present. In contrast, when an element is referred to as being "directly over," "directly above," "directly on," "directly below," "directly under," "directly beneath," "directly connected to" or "directly coupled to" another element or layer, there are no intervening elements or layers present.

Semiconductor devices according to one or more embodiments may include two-dimensional (2D) material-based transistors and their heterostructures. Additionally, the semiconductor devices according to one or more embodiments may also include bipolar junction transistors, lateral diffused metal-oxide semiconductor (LDMOS) transistors, and others.

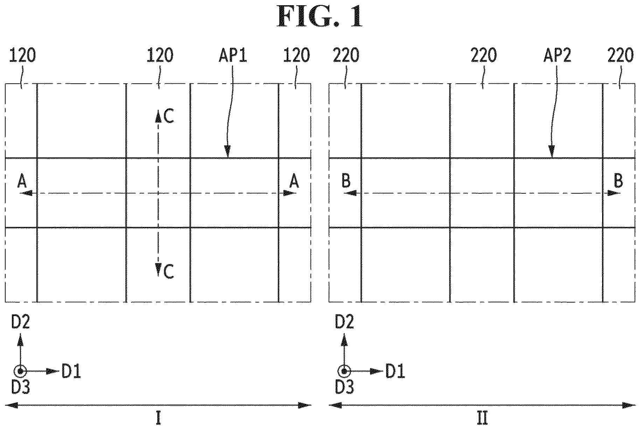

A semiconductor device according to one or more embodiments will hereinafter be described with reference to FIGS. 1 through 7.

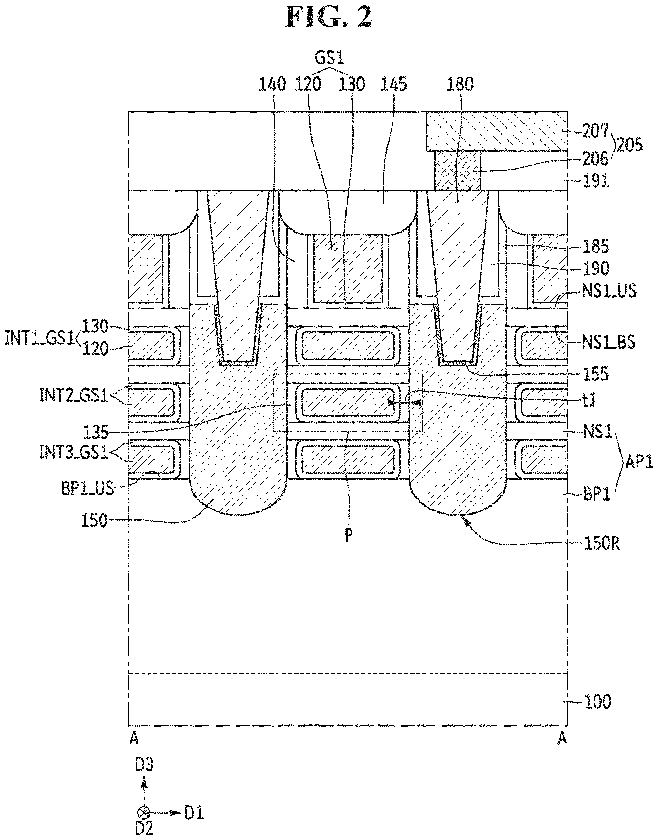

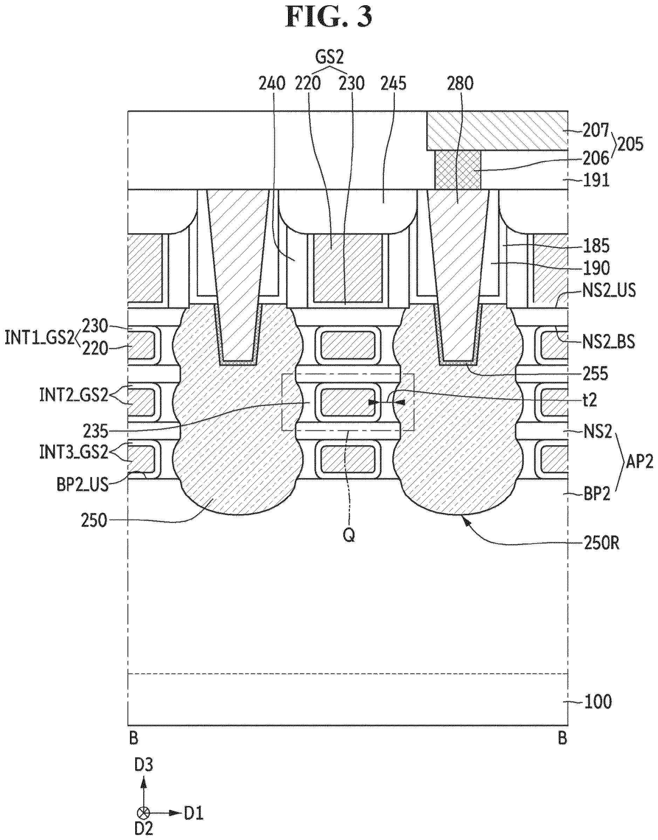

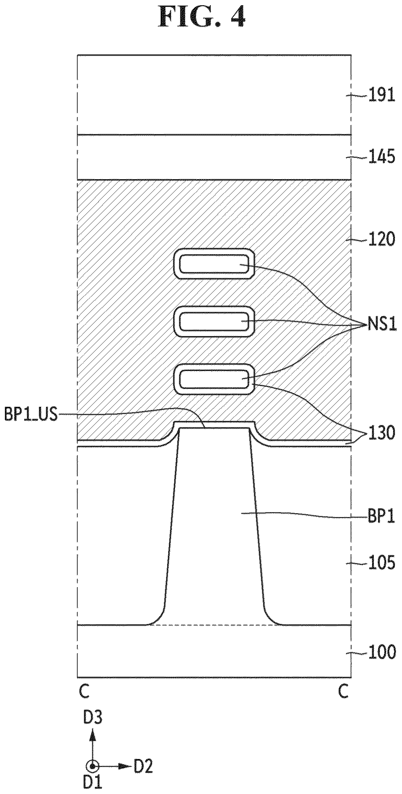

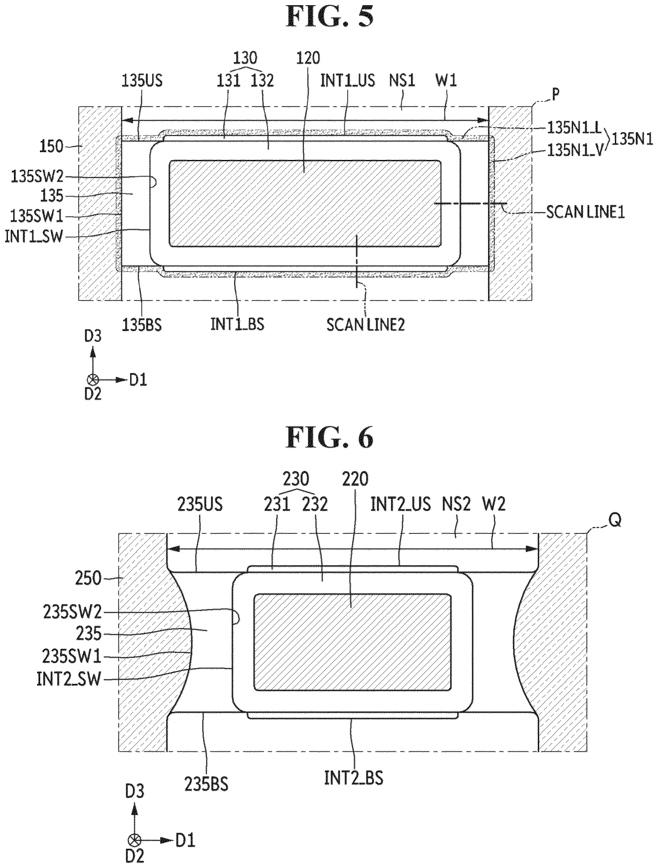

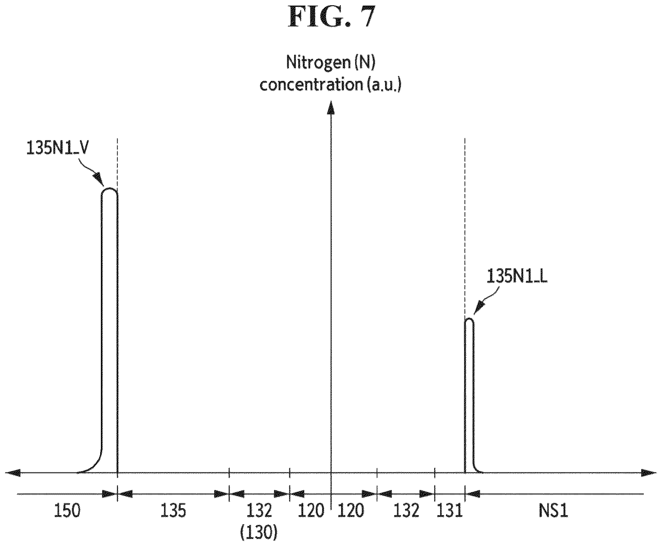

FIG. 1 is a diagram illustrating a semiconductor device according to one or more embodiments. FIG. 2 is a cross-sectional view taken along line A-A of FIG. 1 according to one or more embodiments. FIG. 3 is a cross-sectional view taken along line B-B of FIG. 1 according to one or more embodiments. FIG. 4 is a cross-sectional view taken along line C-C of FIG. 1 according to one or more embodiments. FIG. 5 is an enlarged cross-sectional view of portion P of FIG. 2 according to one or more embodiments. FIG. 6 is an enlarged cross-sectional view of portion Q of FIG. 3 according to one or more embodiments. FIG. 7 is a schematic graph showing the concentration of nitrogen (N) along "SCAN LINE 1" and "SCAN LINE 2" of FIG. 5 according to one or more embodiments.

A cross-sectional view taken in a second direction D2 along each second gate electrode 220 of FIG. 1 may be similar to FIG. 4.

Referring to FIGS. 1 through 7, the semiconductor device according to one or more embodiments may include a first active pattern AP1, a second active pattern AP2, a plurality of first gate electrodes 120, a plurality of second gate electrodes 220, first inner spacers 135, a second inner spacers 235, first source/drain patterns 150, second source/drain patterns 250, and first nitrogen build-up areas 135N1.

A substrate 100 may include a first region I and a second region II. For example, the first and second regions I and II may be adjacent areas. For example, one of the second gate electrodes 220 in the second region II may be a first gate electrode 120 in the first region I. Alternatively, the first and second regions I and II may be separate areas.

The first and second regions I and II may be logic areas, static random-access memory (RAM) (SRAM) areas, or input/output (I/O) areas. For example, the first and second regions I and II may be areas that perform the same function. Alternatively, the first and second regions I and II may be areas that perform different functions.

The first and second regions I and II may be areas where transistors of different conductivity types are formed. For example, the first region I may be an area where N-type metal-oxide semiconductor (MOS) (NMOS) transistors are formed. The second region II may be an area where P-type MOS (PMOS) transistors are formed.

The substrate 100 may be a bulk silicon or silicon-on-insulator (SOI) substrate. Alternatively, the substrate 100 may be a silicon substrate or include other materials, for example, silicon-germanium (SiGe), SiGe-on-insulator (SGOI), indium antimonide, a lead telluride compound, indium arsenide, indium phosphide, gallium arsenide, or gallium antimonide, but embodiments are not limited thereto.

The first active pattern AP1, a plurality of first gate electrodes 120, the first inner spacers 135, and the first source/drain patterns 150 may be disposed in the first region I of the substrate 100. The second active pattern AP2, a plurality of second gate electrodes 220, the second inner spacers 235, and the second source/drain patterns 250 may be disposed in the second region II of the substrate 100.

The first and second active patterns AP1 and AP2 may be disposed on the substrate 100. The first and second active patterns AP1 and AP2 may extend in a first direction D1.

Alternatively, one of the first and second active patterns AP1 and AP2 may extend in the first direction D1, and the other active pattern may extend in the second direction D2. The first and second active patterns AP1 and AP2 will hereinafter be described as both extending in the first direction D1.

The first and second active patterns AP1 and AP2 may be multi-channel active patterns. The first active pattern AP1 may include a first lower pattern BP1 and a plurality of first sheet patterns NS1. The second active pattern AP2 may include a second lower pattern BP2 and a plurality of second sheet patterns NS2.

The first lower pattern BP1 may protrude from the substrate 100. The first lower pattern BP1 may extend in the first direction D1. Similarly, the second lower pattern BP2 may protrude from the substrate 100. The second lower pattern BP2 may also extend in the first direction D1.

The first sheet patterns NS1 may be disposed on an upper surface BP1_US of the first lower pattern BP1. The first sheet patterns NS1 may be spaced apart from the first lower pattern BP1 in a third direction D3. The first sheet patterns NS1 may be spaced apart from one another in the third direction D3.

The second sheet patterns NS2 may be disposed on an upper surface BP2_US of the second lower pattern BP2. The second sheet patterns NS2 may be spaced apart from the second lower pattern BP2 in the third direction D3. The second sheet patterns NS2 may be spaced apart from one another in the third direction D3.

Each of the first sheet patterns NS1 may include an upper surface NS1_US and a lower surface NS1_BS. The upper surfaces NS1_US of the first sheet patterns NS1 may be opposite to the lower surfaces NS1_BS of the first sheet patterns NS1 in the third direction D3.

Each of the second sheet patterns NS2 may include an upper surface NS2_US and a lower surface NS2_BS. The upper surfaces NS2_US of the second sheet patterns NS2 may be opposite to the lower surfaces NS2_BS of the second sheet patterns NS2 in the third direction D3. The third direction D3 may be a direction intersecting both the first and second directions D1 and D2. For example, the third direction D3 may be the thickness direction of the substrate 100. The first direction D1 may be a direction intersecting the second direction D2.

Three first sheet patterns NS1 and three second sheet patterns NS2 are illustrated as being disposed in the third direction D3, but embodiments are not limited thereto.

Each of the first and second lower patterns BP1 and BP2 may be formed by etching part of the substrate 100 or may include an epitaxial layer grown from the substrate 100. Each of the first and second lower patterns BP1 and BP2 may include silicon or germanium, which is an elemental semiconductor material. Additionally, each of the first and second lower patterns BP1 and BP2 may include a compound semiconductor, such as a group IV-IV compound semiconductor or a group III-V compound semiconductor.

The group IV-IV compound semiconductor may include, for example, a binary, ternary, or quaternary compound comprising at least two elements among carbon (C), silicon (Si), germanium (Ge), and tin (Sn), or a compound obtained by doping the binary, ternary, or quaternary compound with a group IV element.

The group III-V compound semiconductor may include, for example, a binary, ternary, or quaternary compound formed by combining at least one of aluminum (Al), gallium (Ga), and indium (In), which are group III elements, with one of phosphorus (P), arsenic (As), and antimony (Sb), which are group V elements.

The first sheet patterns NS1 and the second sheet patterns NS2 may include either Si or Ge, which is an elemental semiconductor material, or a group IV-IV or III-V compound semiconductor. The first sheet patterns NS1 may include the same material as, or a different material from, the first lower pattern BP1. Similarly, the second sheet patterns NS2 may include the same material as, or a different material from, the second lower pattern BP2.

In one or more embodiments, the first and second lower patterns BP1 and BP2 may both be Si lower patterns that include Si, and the first sheet patterns NS1 and the second sheet patterns NS2 may both be Si sheet patterns that include Si.

The width, in the second direction D2, of the first sheet patterns NS1 may increase or decrease in proportion to the width, in the second direction D2, of the upper surface BP1_US of the first lower pattern BP1. Similarly, the width, in the second direction D2, of the second sheet patterns NS2 may increase or decrease in proportion to the width, in the second direction D2, of the upper surface BP2_US of the second lower pattern BP2.

First sheet patterns NS1 that are stacked in the third direction D3 are illustrated as having the same width, and second sheet patterns NS2 that are stacked in the third direction D3, are illustrated as having the same width. However, embodiments are not limited thereto. Alternatively, the width, in the second direction D2, of the first sheet patterns NS1 that are stacked in the third direction D3 may decrease as the first sheet patters NS1 are further away from the first lower pattern BP1. The same description may also be applicable to the second active pattern AP2.

The width, in the second direction D2, of the first active pattern AP1 is illustrated as being the same as the width, in the second direction D2, of the second active pattern AP2, but embodiments are not limited thereto. For reference, the width, in the second direction D2, of the first active pattern AP1 may correspond to the width, in the second direction D2, of the upper surface BP1_US of the first lower pattern BP1.

A field insulating film 105 may be formed on the substrate 100. The field insulating film 105 may be disposed on the sidewalls of the first lower pattern BP1. The field insulating film 105 may not be disposed on the upper surface BP1_US of the first lower pattern BP1.

For example, the field insulating film 105 may generally cover the sidewalls of the first lower pattern BP1. Alternatively, the field insulating film 105 may cover only portions of the sidewalls of the first lower pattern BP1, in which case, a portion of the first lower pattern BP1 may protrude in the third direction D3 beyond the upper surface of the field insulating film 105.

Each of the first sheet patterns NS1 may be disposed higher than the upper surface of the field insulating film 105, and the same description may also be applicable to the relationship between the field insulating film 105 and the second lower pattern BP2.

The field insulating film 105 may include, for example, an oxide film, a nitride film, an oxynitride film, or a combination thereof. The field insulating film 105 is illustrated as being a single film, but embodiments are not limited thereto.

A plurality of first gate structures GS1 may be disposed the substrate 100. Each of the first gate structures GS1 may extend in the second direction D2. The first gate structures GS1 may be spaced apart from one another in the first direction D1. The first gate structures GS1 may be adjacent to one another in the first direction D1. For example, the first gate structures GS1 may be disposed on both sides of the first source/drain patterns 150 in the first direction D1.

The first gate structures GS1 may be disposed on the first active pattern AP1. The first gate structures GS1 may intersect the first active pattern AP1. The first gate structures GS1 may intersect the first lower pattern BP1. The first gate structures GS1 may surround each of the first sheet patterns NS1.

The first gate structures GS1 may include the first gate electrodes 120 and a first gate insulating film 130.

The first gate structures GS1 may include a plurality of first inner gates (INT1_GS1, INT2_GS1, and INT3_GS1), which may be disposed between each pair of adjacent first sheet patterns NS1 in the third direction D3, and between the first lower pattern BP1 and the lowermost one of the first sheet patterns NS1. The first inner gates (INT1_GS1, INT2_GS1, and INT3_GS1) may be disposed between the upper surface BP1_US of the first lower pattern BP1 and the lower surfaces NS1_BS of the first sheet patterns NS1, and between the upper surfaces NS1_US of the first sheet patterns NS1 and the lower surfaces NS1_BS of the first sheet patterns NS1 that respectively face the upper surfaces NS1_US of the first sheet patterns NS1 in the third direction D3.

The number of the first inner gates (INT1_GS1, INT2_GS1, and INT3_GS1) may be proportional to the number of the first sheet patterns NS1 included in the active pattern AP1. For example, the number of the first inner gates (INT1_GS1, INT2_GS1, and INT3_GS1) may be the same as the number of the first sheet patterns NS1. Since the first active pattern AP1 includes a plurality of first sheet patterns NS1, the first gate structures GS1 may include a plurality of first inner gates (INT1_GS1, INT2_GS1, and INT3_GS1).

The first inner gates (INT1_GS1, INT2_GS1, and INT3_GS1) may contact the upper surface BP1_US of the first lower pattern BP1, the upper surfaces NS1_US of the first sheet patterns NS1, and the lower surfaces NS1_BS of the first sheet patterns NS1.

A case where there are three first inner gates (INT1_GS1, INT2_GS1, and INT3_GS1) will hereinafter be described.

Each of the first gate structures GS1 may include a first sub-inner gate INT1_GS1, a second sub-inner gate INT2_GS1, and a third sub-inner gate INT3_GS1. In each of the first gate structures GS1, the first, second, and third sub-inner gates INT1_GS1, INT2_GS1, and INT3_GS1 may be sequentially disposed on the first lower pattern BP1.

The third sub-inner gates INT3_GS1 may be disposed between the first lower pattern BP1 and the lowermost one of the first sheet patterns NS1. The third sub-inner gates INT3_GS1 may be disposed at the lowest position among the first inner gates (INT1_GS1, INT2_GS1, and INT3_GS1). The third sub-inner gates INT3_GS1 may be lowermost first inner gates. The third sub-inner gates INT3_GS1 may contact the upper surface BP1_US of the first lower pattern BP1.

The first sub-inner gates INT1_GS1 and the second sub-inner gates INT2_GS1 may be disposed between each pair of adjacent first sheet patterns NS1 in the third direction D3. The first sub-inner gates INT1_GS1 may be disposed at the highest position among the first inner gates (INT1_GS1, INT2_GS1, and INT3_GS1). The first sub-inner gates INT1_GS1 may be uppermost first inner gates. The first sub-inner gates INT1_GS1 may contact the lower surfaces NS1_BS of uppermost first sheet patterns NS1. The second sub-inner gates INT2_GS1 may be disposed between the first sub-inner gates INT1_GS1 and the third sub-inner gates INT3_GS1.

The first inner gates (INT1_GS1, INT2_GS1, and INT3_GS1) may include the first gate electrodes 120 and the first gate insulating film 130, which are disposed between each pair of adjacent first sheet patterns NS1, and between the first lower pattern BP1 and the lowermost one of the first sheet patterns NS1.

Each of the first inner gates (INT1_GS1, INT2_GS1, and INT3_GS1) may include first and second surfaces INT1_US and INT1_BS, which are opposite to each other in the third direction D3, and sidewalls INT1_SW, which connect the first and second surfaces INT1_US and the second surface INT1_BS. The first surfaces INT1_US of the first inner gates (INT1_GS1, INT2_GS1, and INT3_GS1) may face the lower surfaces NS1_BS of the first sheet patterns NS1. The second surfaces INT1_BS of the first inner gates (INT1_GS1, INT2_GS1, and INT3_GS1) may face the upper surfaces NS1_US of the first sheet patterns NS1 or the upper surface BP1_US of the first lower pattern BP1.

A plurality of second gate structures GS2 may be disposed on substrate 100. Each of the second gate structures GS2 may extend in the second direction D2. The second gate structures GS2 may be spaced apart from one another in the first direction D1. The second gate structures GS2 may be adjacent to one another in the first direction D1. For example, the second gate structures GS2 may be disposed on both sides of the second source/drain patterns 250 in the first direction D1.

The second gate structures GS2 may be disposed on the second active pattern AP2. The second gate structures GS2 may intersect the second active pattern AP2. The second gate structures GS2 may intersect the second lower pattern BP2. The second gate structures GS2 may surround each of the second sheet patterns NS2.

The second gate structures GS2 may include second gate electrodes 220 and a second gate insulating film 230.

The second gate structures GS2 may include a plurality of second inner gates (INT1_GS2, INT2_GS2, and INT3_GS2), which are disposed between each pair of adjacent second sheet patterns NS2 in the third direction D3, and between the second lower pattern BP2 and the lowermost one of the second sheet patterns NS2. The second inner gates (INT1_GS2, INT2_GS2, and INT3_GS2) may contact the upper surface BP2_US of the second lower pattern BP2 and the upper surfaces NS2_US and the lower surfaces NS2_BS of the second sheet patterns NS2.

Each of the second gate structures GS2 may include a fourth sub-inner gate INT1_GS2, a fifth sub-inner gate INT2_GS2, and a sixth sub-inner gate INT3_GS2. The sixth sub-inner gates INT3_GS2 may be disposed between the second lower pattern BP2 and the second sheet patterns NS2. The sixth sub-inner gates INT3_GS2 may be lowermost second inner gates. The fourth sub-inner gates INT1_GS2 may be disposed at the highest position among the second inner gates (INT1_GS2, INT2_GS2, and INT3_GS2). The fourth sub-inner gates INT1_GS2 may be uppermost second inner gates. The fifth sub-inner gates INT2_GS2 may be disposed between the fourth sub-inner gates INT1_GS2 and the sixth sub-inner gates INT3_GS2.

The second inner gates (INT1_GS2, INT2_GS2, and INT3_GS2) may include the second gate electrodes 220 and the second gate insulating film 230, which are disposed between each pair of adjacent second sheet patterns NS2, and between the second lower pattern BP2 and the lowermost one of the second sheet patterns NS2.

Each of the second inner gates (INT1_GS2, INT2_GS2, and INT3_GS2) may include first and second surfaces INT2_US and INT2_BS, which are opposite to each other in the third direction D3, and sidewalls INT2_SW, which connect the first and second surfaces INT2_US and INT2_BS. The first surfaces INT2_US of the second inner gates (INT1_GS2, INT2_GS2, and INT3_GS2) may face the lower surfaces NS2_BS of the second sheet patterns NS2. The second surfaces INT2_BS of the second inner gates (INT1_GS2, INT2_GS2, and INT3_GS2) may face the upper surfaces NS2_US of the second sheet patterns NS2 or the upper surface BP2_US of the second lower pattern BP2.

When the first and second active patterns AP1 and AP2 extend in different directions, the direction in which the second gate structures GS2 extend differs from the direction in which the first gate structures GS1 extend. For example, when the first active pattern AP1 extends in direction D1 and the second active pattern AP2 extends in direction D2, the first gate structures GS1 may extend in direction D1, and the second gate structures GS2 may extend in direction D2.

The first gate electrodes 120 may be disposed on the first lower pattern BP1. The first gate electrodes 120 may intersect the first lower pattern BP1. The first gate electrodes 120 may surround the first sheet patterns NS1. Portions of the first gate electrodes 120 may be disposed between each pair of adjacent first sheet patterns NS1, and between the first lower pattern BP1 and the first sheet patterns NS1.

The second gate electrodes 220 may be disposed on the second lower pattern BP2. The second gate electrodes 220 may intersect the second lower pattern BP2. Portions of the second gate electrodes 220 may be disposed between each pair of adjacent second sheet patterns NS2, and between the second lower pattern BP2 and the second sheet patterns NS2. Although not illustrated, the second gate electrodes 220 may surround the second sheet patterns NS2.

Each pair of adjacent first gate electrodes 120 in the first direction D1 may be spaced apart by a first distance. Similarly, each pair of adjacent second gate electrodes 220 in the first direction D1 may be spaced apart by a second distance. For example, the distance by which the first gate electrodes 120 are spaced apart in the first direction D1 may be the same as the distance by which the second gate electrodes 220 are spaced apart.

For example, the distance, in the first direction D1, between two first gate electrodes 120 with a first source/drain pattern 150 interposed therebetween may correspond to the distance between opposing sidewalls, in the first direction D1, of the two first gate electrodes 120 with the first source/drain pattern 150 interposed therebetween.

For example, a length W1, in the first direction D1, of the first sheet patterns NS1 may be equal to or greater than a length W2, in the first direction D1, of the second sheet patterns NS2. In one or more embodiments, the length W1 of the first sheet patterns NS1 may be greater than the length W2 of the second sheet patterns NS2.

The lengths W1 and W2 may be compared for each pair of first and second sheet patterns NS 1 and NS2 at the same height or level. That is, in some examples where the lengths of the sheet patterns are compared at the same heights or levels, the length W1 may correspond to the second first sheet pattern NS1 from the first lower pattern BP1, and the length W2 may correspond to the second second sheet pattern NS2 from the second lower pattern BP2.

The length W1 of the first sheet patterns NS1 may be measured at, for example, the midpoint between opposing upper and lower surfaces NS1_US and NS1_BS, in the third direction D3, of each of the first sheet patterns NS1.

For example, the length W1 of the first sheet patterns NS1 may differ from the length W2 of the second sheet patterns NS2 depending on the shapes of first source/drain recesses 150R and second source/drain recesses 250R.

In one or more embodiments, the thickness, in the first direction D1, of the first gate spacers 140 and the second gate spacers 240 may vary depending on the sequence in which the first source/drain recesses 150R and the second source/drain recesses 250R are formed. In this case, the length W1 of the first sheet patterns NS1 may differ from the length W2 of the second sheet patterns NS2 depending on the thickness, in the first direction D1, of the first gate spacers 140 and the second gate spacers 240.

The first gate electrodes 120 and the second gate electrodes 220 may include at least one of a metal, a metal alloy, a conductive metal nitride, a metal silicide, a doped semiconductor material, a conductive metal oxide, and a conductive metal oxynitride. The first gate electrodes 120 may include, for example, titanium nitride (TiN), tantalum carbide (TaC), tantalum nitride (TaN), titanium silicon nitride (TiSiN), tantalum silicon nitride (TaSiN), tantalum titanium nitride (TaTiN), titanium aluminum nitride (TiAlN), tantalum aluminum nitride (TaAlN), tungsten nitride (WN), ruthenium (Ru), titanium aluminum (TiAl), titanium aluminum carbonitride (TiAlCN), titanium aluminum carbide (TiAlC), titanium carbide (TiC), tantalum carbonitride (TaCN), tungsten (W), Al, copper (Cu), cobalt (Co), titanium (Ti), tantalum (Ta), nickel (Ni), platinum (Pt), nickel platinum (NiPt), niobium (Nb), niobium nitride (NbN), niobium carbide (NbC), molybdenum (Mo), molybdenum nitride (MoN), molybdenum carbide (MoC), tungsten carbide (WC), rhodium (Rh), palladium (Pd), iridium (Ir), osmium (Os), silver (Ag), gold (Au), zinc (Zn), vanadium (V), and a combination thereof, but embodiments are not limited thereto. The conductive metal oxide and conductive metal oxynitride may include oxidized forms of the aforementioned materials, but embodiments are not limited thereto.

The first gate electrodes 120 may be disposed on both sides of the first source/drain patterns 150 that will be described later. The first gate structures GS1 may be disposed on both sides of the first source/drain patterns 150 in the first direction D1.

For example, two first gate electrodes 120 on both sides of each of the first source/drain patterns 150 may both be normal gate electrodes that are both used as the gates of transistor. Alternatively, one of these two first gate electrodes 120 may be a normal gate electrode, and the other first gate electrode 120 may be a dummy gate electrode.

The second gate electrodes 220 may be disposed on both sides of the second source/drain patterns 250. The second gate structures GS2 may be disposed on both sides, in the first direction D1, of the second source/drain patterns 250.

For example, two second gate electrodes 220 on both sides of each of the second source/drain patterns 250 may both be normal gate electrodes that are both used as the gates of transistor. Alternatively, one of these two second gate electrodes 220 may be a normal gate electrode, and the other second gate electrode 220 may be a dummy gate electrode.

The first gate insulating film 130 may extend along the upper surface of the field insulating film 105 and the upper surface BP1_US of the first lower pattern BP1. The first gate insulating film 130 may surround a plurality of first sheet patterns NS1. The first gate insulating film 130 may be disposed along the circumferences of the first sheet patterns NS1. The first gate electrodes 120 may be disposed on the first gate insulating film 130. The first gate insulating film 130 may be disposed between the first gate electrodes 120 and the first sheet patterns NS1. Portions of the first gate insulating film 130 may be disposed between each pair of first sheet patterns NS 1 in the third direction D3, and between the first lower pattern BP1 and the first sheet patterns NS1.

The first gate insulating film 130 may include a first gate interface insulating film 131 and a first gate high-k insulating film 132. The first gate high-k insulating film 132 may be disposed between the first gate interface insulating film 131 and the first gate electrodes 120.

Referring to FIG. 5, the first gate interface insulating film 131 may be disposed between the first sheet patterns NS1 and the first gate high-k insulating film 132.

The first gate interface insulating film 131 may extend along the upper surface BP1_US of the first lower pattern BP1. The first gate interface insulating film 131 may be disposed along the circumferences of the first sheet patterns NS1.

The first gate interface insulating film 131 may not extend along the upper surface of the field insulating film 105. The first gate interface insulating film 131 may not extend along the boundaries of the first inner spacers 135 and the first gate high-k insulating film 132. The first gate interface insulating film 131 may not extend along the sidewalls of the first gate spacers 140 that will be described later.

However, the first gate interface insulating film 131 may extend along the upper surface of the field insulating film 105 and along the sidewalls of the first gate spacers 140, depending on how it is formed. The first gate interface insulating film 131 may extend along the boundaries of the first inner spacers 135 and the first gate high-k insulating film 132.

The first gate high-k insulating film 132 may extend along the upper surface of the field insulating film 105 and the upper surface BP1_US of the first lower pattern BP1. The first gate high-k insulating film 132 may extend along the first inner spacers 135. The first gate high-k insulating film 132 may be disposed along the circumferences of the first sheet patterns NS1. The first gate high-k insulating film 132 may extend along the sidewalls of the first gate spacers 140 that will be described later.

The description of the second gate insulating film 230 is similar to that of the first gate insulating film 130, and thus, the second gate insulating film 230 will hereinafter be briefly described.

The second gate electrodes 220 may be disposed on the second gate insulating film 230. The second gate insulating film 230 may be disposed between the second gate electrodes 220 and the second sheet patterns NS2.

The second gate insulating film 230 may include a second gate interface insulating film 231 and a second gate high-k insulating film 232. The second gate high-k insulating film 232 may be disposed between the second gate interface insulating film 231 and the second gate electrodes 220.

The first and second gate interface insulating films 131 and 231 may include at least one of silicon oxide, silicon-germanium oxide, and germanium oxide. The first and second gate interface insulating films 131 and 231 may further include at least one of boron (B), P, C, As, Sb, and bismuth (Bi), but embodiments are not limited thereto.

The first and second gate high-k insulating films 132 and 232 may include, for example, at least one of boron nitride, hafnium oxide, hafnium silicon oxide, hafnium aluminum oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, and lead zinc niobate.

The semiconductor device according to one or more embodiments may include a negative capacitance (NC) field-effect transistor (FET) utilizing a negative capacitor. For example, the first gate high-k insulating film 132 and/or the second gate high-k insulating film 232 may include a ferroelectric material film with ferroelectric properties. In another example, the first gate high-k insulating film 132 and/or the second gate high-k insulating film 232 may include both a ferroelectric material film with ferroelectric properties and a paraelectric material film with paraelectric properties.

The ferroelectric material film may have negative capacitance, and the paraelectric material film may have positive capacitance. For example, if two or more capacitors are connected in series, and each of the capacitors has a positive capacitance, the total capacitance of the capacitors is reduced compared to the capacitance of each of the capacitors. Conversely, if at least one of the capacitors has a negative capacitance, the total capacitance of the capacitors may have a positive value and may be greater than the absolute value of the capacitance of each of the capacitors.

When a ferroelectric material film with a negative capacitance and a paraelectric material film with a positive capacitance are connected in series, the total capacitance of the ferroelectric and paraelectric material films may increase. Utilizing this capacitance increase, the transistor including the ferroelectric material film may have a subthreshold swing (SS) of 60 mV/decade or less at room temperature.

The ferroelectric material film may have ferroelectric properties. For example, the ferroelectric material film may include at least one of hafnium oxide, hafnium zirconium oxide, barium strontium titanium oxide, barium titanium oxide, and lead zirconium titanium oxide. The hafnium zirconium oxide may be, for example, a material obtained by doping hafnium oxide with zirconium (Zr). Alternatively, the hafnium zirconium oxide may be the compound of hafnium (Hf), Zr, and oxygen (O).

The ferroelectric material film may further include a dopant. For example, the dopant may include at least one of Al, Ti, Nb, lanthanum (La), yttrium (Y), magnesium (Mg), Si, calcium (Ca), cerium (Ce), dysprosium (Dy), erbium (Er), gadolinium (Gd), Ge, scandium (Sc), strontium (Sr), and Sn. The type of the dopant included in the ferroelectric material film may vary depending on the type of the ferroelectric material included in the ferroelectric material film.

When the ferroelectric material film includes hafnium oxide, the dopant included in the ferroelectric material film may include at least one of Gd, Si, Zr, Al, and Y.

In examples where the dopant is Al, the ferroelectric material film may contain 3 to 8 atomic % (at%) of Al. The proportion of the dopant may be the ratio of Al to the sum of Hf and Al.

In examples where the dopant is Si, the ferroelectric material film may contain 2 to 10 at% of Si. In examples where the dopant is Y, the ferroelectric material film may contain 2 to 10 at% of Y. If the dopant is Gd, the ferroelectric material film may contain 1 to 7 at% of Gd. In examples where the dopant is Zr, the ferroelectric material film may contain 50 to 80 at% of Zr.

The paraelectric material film may have paraelectric properties. The paraelectric material film may include, for example, at least one of silicon oxide and a high-k metal oxide. The high-k metal oxide may include at least one of hafnium oxide, zirconium oxide, and aluminum oxide, but embodiments are not limited thereto.

The ferroelectric material film and the paraelectric material film may include the same material. The ferroelectric material film may have ferroelectric properties, but the paraelectric material film may not have ferroelectric properties. For example, if both the ferroelectric and paraelectric material films include hafnium oxide, the crystal structure of the hafnium oxide in the ferroelectric material film may differ from the crystal structure of the hafnium oxide in the paraelectric material film.

The ferroelectric material film may have a thickness that exhibits ferroelectric properties. For example, the thickness of the ferroelectric material film may be 0.5 to 10 nm, but embodiments are not limited thereto. Since the critical thickness for exhibiting ferroelectric properties may vary from one ferroelectric material to another, the thickness of the ferroelectric material film may vary depending on its material.

For example, the first gate high-k insulating film 132 and/or the second gate high-k insulating film 232 may include a single ferroelectric material film. Alternatively, the first gate high-k insulating film 132 and/or the second gate high-k insulating film 232 may include multiple ferroelectric material films that spaced apart from each other. The first gate high-k insulating film 132 and/or the second gate high-k insulating film 232 may have a layered film structure where multiple ferroelectric material films and multiple paraelectric material films are stacked alternating with one another.

The first gate spacers 140 may be disposed on the sidewalls of the first gate electrodes 120. The first gate spacers 140 may not be disposed between the first lower pattern BP1 and the lowermost one of the first sheet patterns NS1, and may not be disposed between each pair of adjacent first sheet patterns NS1 in the third direction D3.

The second gate spacers 240 may be disposed on the sidewalls of the second gate electrodes 220. The second gate spacers 240 may not not disposed between the second lower pattern BP2 and the lowermost one of the second sheet patterns NS2, and may not be disposed between each pair of adjacent second sheet patterns NS2 in the third direction D3.

The first gate spacers 140 and the second gate spacers 240 may include, for example, at least one of silicon nitride (SiN), silicon oxynitride (SiON), silicon dioxide (SiO₂), silicon oxycarbonitride (SiOCN), silicon boron nitride (SiBN), silicon oxiboronitride (SiOBN), SiOC, and a combination thereof. The first gate spacers 140 and the second gate spacers 240 are illustrated as being single films, but embodiments are not limited thereto.

The first gate capping patterns 145 may be disposed on the first gate electrodes 120 and the first gate spacers 140. Similarly, the second gate capping patterns 245 may be disposed on the second gate electrodes 220 and the second gate spacers 240. The upper surfaces of the first gate capping patterns 145 and the upper surfaces of the second gate capping patterns 245 may be disposed on the same plane as the upper surface of a first interlayer insulating film 190.

Alternatively, the first gate capping patterns 145 may be disposed between the first gate spacers 140, and the second gate capping patterns 245 may be disposed between the second gate spacers 240.

The first gate capping patterns 145 and the second gate capping patterns 245 may include, for example, at least one of SiN, SiON, silicon carbonitride (SiCN), SiOCN, and a combination thereof. The first gate capping patterns 145 and the second gate capping patterns 245 may include a material with an etch selectivity to the first interlayer insulating film 190.

Alternatively, the first gate capping patterns 145 may not be disposed on the first gate electrodes 120. The second gate capping patterns 245 may not be disposed on the second gate electrodes 220.

The first source/drain patterns 150 may be disposed on the first active pattern AP1. The first source/drain patterns 150 may be disposed on the first lower pattern BP1. The first source/drain patterns 150 may be connected to the first sheet patterns NS1. The first source/drain patterns 150 may contact the first sheet patterns NS1.

The first source/drain patterns 150 may be disposed on the sides of the first gate structures GS1. The first source/drain patterns 150 may be disposed between each pair of adjacent first gate structures GS1 in the first direction D1. For example, the first source/drain patterns 150 may be disposed on both sides of the first gate structures GS1. Alternatively, the first source/drain patterns 150 may be disposed on one side, but not on the other side, of each of the first gate structures GS1.

The second source/drain patterns 250 may be disposed on the second active pattern AP2. The second source/drain patterns 250 may be disposed on the second lower pattern BP2. The second source/drain patterns 250 may be connected to the second sheet patterns NS2. The second source/drain patterns 250 may contact the second sheet patterns NS2.

The second source/drain patterns 250 may be disposed on the sides of the second gate structures GS2. The second source/drain patterns 250 may be disposed between each pair of adjacent second gate structures GS2 in the first direction D1. For example, the second source/drain patterns 250 may be disposed on both sides of the second gate structures GS2. Alternatively, the second source/drain patterns 250 may be disposed on one side, but not on the other side, of each of the second gate structures GS2.

The first source/drain patterns 150 and the second source/drain patterns 250 may be included as the sources/drains of transistors that use the first sheet patterns NS1 and the second sheet patterns NS2 as channel regions.

The first source/drain patterns 150 may be disposed within the first source/drain recesses 150R. The second source/drain patterns 250 may be disposed within the second source/drain recesses 250R. The first source/drain recesses 150R and the second source/drain recesses 250R extend in the third direction D3. The first source/drain recesses 150R may be defined between each pair of adjacent first gate structures GS1 in the first direction D1. The second source/drain recesses 250R may be defined between each pair of adjacent second gate structures GS2 in the second direction D2.

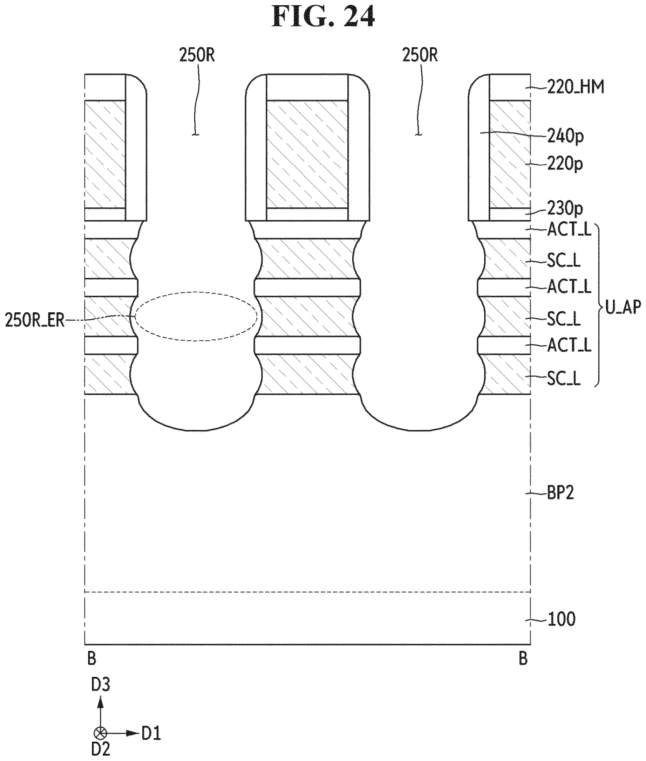

The sidewalls of the second source/drain recesses 250R may have a wavy form. The second source/drain recesses 250R may include a plurality of width expansion areas ("250R_ER" of FIG. 24). Each of the width expansion areas 250R_ER may have portions whose width increases in the first direction D1 as the distance increases away from the upper surface BP2_US of the second lower pattern BP2 and portions whose width decreases in the first direction D1 as the distance increases away from the upper surface BP2_US of the second lower pattern BP2.

The sidewalls of the first source/drain recesses 150R, unlike the sidewalls of the second source/drain recesses 250R, may not have a wavy form. Alternatively, the sidewalls of the second source/drain recesses 250R may not have a wavy form. The sidewalls of the first source/drain recesses 150R may have a wavy form.

The lower surfaces of the first source/drain recesses 150R may be defined by the first lower pattern BP1. The lower surfaces of the second source/drain recesses 250R may be defined by the second lower pattern BP2.

The first source/drain patterns 150 and the second source/drain patterns 250 may include epitaxial patterns. The first source/drain patterns 150 and the second source/drain patterns 250 may include a semiconductor material.

The first source/drain patterns 150 and the second source/drain patterns 250 may include, for example, an elemental semiconductor material such as Si or Ge. Additionally, the first source/drain patterns 150 and the second source/drain patterns 250 may include a binary compound, a ternary compound, or a compound doped with a group IV element, containing at least two of C, Si, Ge, and Sn. For example, the first source/drain patterns 150 and the second source/drain patterns 250 may include a material such as Si, SiGe, or silicon carbide (SiC), but embodiments are not limited thereto.

The first source/drain patterns 150 and the second source/drain patterns 250 may include impurities doped into the semiconductor material. The first source/drain patterns 150 may include n-type impurities. For example, the n-type impurities may include at least one of P, As, Sb, and Bi. The second source/drain patterns 250 may include p-type impurities. For example, the p-type impurities may include at least one of B and Ga.

The first source/drain patterns 150 and the second source/drain patterns 250 are illustrated as being single films, but embodiments are not limited thereto.

The first inner spacers 135 may be disposed between each pair of adjacent first sheet patterns NS1 in the third direction D3, and between the lowermost one of the first sheet patterns NS1 and the first lower pattern BP1. The first inner spacers 135 may be disposed between the first source/drain patterns 150 and the first inner gates (INT1_GS1, INT2_GS1, and INT3_GS1).

For example, the first inner spacers 135 may contact the first inner gates (INT1_GS1, INT2_GS1, and INT3_GS1). The first inner spacers 135 may contact the first gate insulating film 130 included in the first inner gates (INT1_GS1, INT2_GS1, and INT3_GS1). The first inner spacers 135 may contact the first source/drain patterns 150.

Each of the first inner spacers 135 may include first and third surfaces 135US and 135BS, which are opposite to each other in the third direction D3, and may further include first and second sidewalls 135SW1 and 135SW2, which connect the first and second surfaces 135US and 135BS. The first sidewalls 135SW1 of the first inner spacers 135 may be opposite to the second sidewalls 135SW2 of the first inner spacers 135 in the first direction D1.

The first surfaces 135US and the second surfaces 135BS of the first inner spacers 135 may contact the first sheet patterns NS1 or the first lower pattern BP1. The first sidewalls 135SW1 of the first inner spacers 135 may face the first source/drain patterns 150. The first sidewalls 135SW1 of the first inner spacers 135 may be the boundaries between the first inner spacers 135 and the first source/drain patterns 150. The second sidewalls 135SW2 of the first inner spacers 135 may face the first inner gates (INT1_GS1, INT2_GS1, and INT3_GS1). The second sidewalls 135SW2 of the first inner spacers 135 may be the boundaries between the first inner spacers 135 and the first inner gates (INT1_GS1, INT2_GS1, and INT3_GS1).

In a cross-sectional view, the first sidewalls 135SW1 of the inner spacers 135 may be flat, and the second sidewalls 135SW2 of the inner spacers 135 may have a concave shape. However, embodiments are not limited to this.

The second inner spacers 235 may be disposed between each pair of adjacent second sheet patterns NS2 in the third direction D3, and between the lowermost one of the second sheet patterns NS2 and the second lower patterns BP2. The second inner spacers 235 may be disposed between the second source/drain patterns 250 and the second inner gates (INT1_GS2, INT2_GS2, and INT3_GS2).

For example, the second inner spacers 235 may contact the second inner gates (INT1_GS2, INT2_GS2, and INT3_GS2). The second inner spacers 235 may contact the second gate insulating film 230 included in the second inner gates (INT1_GS2, INT2_GS2, and INT3_GS2). The second inner spacers 235 may contact the second source/drain patterns 250.

Each of the second inner spacers 235 may include first and second surfaces 235US and 235BS, which are opposite to each other in the third direction D3, and may further include first and second sidewalls 235SW1 and 235SW2, which connect the first and second surfaces 235US and 235BS. The first sidewalls 235SW1 of the second inner spacers 235 may be opposite to the second sidewalls 235SW2 of the second inner spacers 235 in the first direction D1.

The first surfaces 235US and the second surfaces 235BS of the second inner spacers 235 may contact the second sheet patterns NS2 or the second lower pattern BP2. The first sidewalls 235SW1 of the second inner spacers 235 may face the second source/drain patterns 250. The first sidewalls 235SW1 of the second inner spacers 235 may be the boundaries between the second inner spacers 235 and the second source/drain patterns 250. The second sidewalls 235SW2 of the second inner spacers 235 may face the second inner gates (INT1_GS2, INT2_GS2, and INT3_GS2). The second sidewalls 235SW2 of the second inner spacers 235 may be the boundaries between the second inner spacers 235 and the second inner gates (INT1_GS2, INT2_GS2, and INT3_GS2).

In a cross-sectional view, the first sidewalls 235SW1 of the second inner spacers 235 may have a concave shape, and the second sidewalls 235SW2 of the second inner spacers 235 may have a concave shape, but embodiments are not limited thereto.

For example, a thickness 11, in the first direction D1, of the first inner spacers 135 may be less than a thickness t2, in the first direction D1, of the second inner spacers 235. Alternatively, the thickness t1 of the first inner spacers 135 may be the same as the thickness t2 of the second inner spacers 235. For example, the thickness t1 of the first inner spacers 135 may be measured with respect to the midpoint between the first and second surfaces 135US and 135BS of each of the first inner spacers 135.

The first inner spacers 135 and the second inner spacers 235 may include an insulating material. For example, the first inner spacers 135 and the second inner spacers 235 may include silicon oxide.

First nitrogen build-up areas 135N1 may extend along the boundaries between the first source/drain patterns 150 and the first inner spacers 135. The first nitrogen build-up areas 135N1 may extend along the boundaries between the first inner gates (INT1_GS1, INT2_GS1, and INT3_GS1) and the first sheet patterns NS1. The first nitrogen build-up areas 135N1 may extend along the boundaries between the first lower pattern BP1 and the third inner gates INT3_GS1. In FIGS. 2 and 5, the first nitrogen build-up areas 135N1 may be formed around the circumferences of the first inner gates (INT1_GS1, INT2_GS1, and INT3_GS1).

The first nitrogen build-up areas 135N1 may include vertical portions 135N1_V and horizontal portions 135N1_L.

The vertical portions 135N1_V of the first nitrogen build-up areas 135N1 may extend along the boundaries between the first source/drain patterns 150 and the first inner spacers 135. For example, the vertical portions 135N1_V of the first nitrogen build-up areas 135N1 may extend along the first sidewalls 135SW1 of the first inner spacers 135. The vertical portions 135N1_V of the first nitrogen build-up areas 135N1 may extend along the sidewalls INT1_SW of the first inner gates (INT1_GS1, INT2_GS1, and INT3_GS1).

The horizontal portions 135N1_L of the first nitrogen build-up areas 135N1 may extend along the boundaries between the first inner gates (INT1_GS1, INT2_GS1, and INT3_GS1) and the first sheet patterns NS1. The horizontal portions 135N1_L of the first nitrogen build-up areas 135N1 may extend along the boundaries between the first lower pattern BP1 and the third inner gates INT3_GS1. The horizontal portions 135N1_L of the first nitrogen build-up areas 135N1 may extend along the first surfaces INT1_US of the first inner gates (INT1_GS1, INT2_GS1, and INT3_GS1) and the first surfaces 135US of the first inner spacers 135. The horizontal portions 135N1_L of the first nitrogen build-up areas 135N1 may extend along the second surfaces INT1_BS of the first inner gates (INT1_GS1, INT2_GS1, and INT3_GS1) and the second surfaces 135BS of the first inner spacers 135.

The vertical portions 135N1_V of the first nitrogen build-up areas 135N1 may be formed within the first source/drain patterns 150. The vertical portions 135N1_V of the first nitrogen build-up areas 135N1 may correspond to areas within the first source/drain patterns 150 where N is built up. The horizontal portions 135N1_L of the first nitrogen build-up areas 135N1 may be formed within the first sheet patterns NS1. The horizontal portions 135N1_L of the first nitrogen build-up areas 135N1 may correspond to areas within the first sheet patterns NS1 where N is built up. The horizontal portions 135N1_L of the first nitrogen build-up areas 135N1 may be formed within the first lower pattern BP1.

The areas where N is built up may refer to areas with a higher concentration of N (/cm³) than surrounding areas, but the concentration of N is may not be zero in other areas.

In FIG. 5, the horizontal portions 135N1_L of the first nitrogen build-up areas 135N1 are illustrated as being formed continuously along the surfaces of the first sheet patterns NS1, but embodiments are not limited thereto. For example, the horizontal portions 135N1_L of the first nitrogen build-up areas 135N1 may include both areas with a higher concentration of N built up and areas with a lower concentration of N built up. In another example, the horizontal portions 135N1_L of the first nitrogen build-up areas 135N1 may include both areas with N built up and areas with no N built up. The areas with no N built up may not necessarily indicate an N concentration of 0 and may appear as having no N due to the detection limits of detection equipment.

For example, the concentration of N may be higher in the vertical portions 135N1_V of the first nitrogen build-up areas 135N1 than in the horizontal portions 135N1_L of the first nitrogen build-up areas 135N1. In FIG. 7, the absence of an N peak within the first inner spacers 135 does not necessarily imply the absence of N within the first inner spacers 135.

The N built up on the surfaces of the first sheet patterns NS1 may function as a fixed charge. Since the first sheet patterns NS1 are used as the channel regions of NMOS transistors, the N built up on the surfaces of the first sheet patterns NS1 may adjust the threshold voltage of the transistors, and may enhance the performance of the NMOS transistors.

In FIGS. 3 and 6, nitrogen build-up areas may not be formed around the circumferences of the second inner gates (INT1_GS2, INT2_GS2, and INT3_GS2). In other words, nitrogen build-up areas may not be formed along the boundaries between the second source/drain patterns 250 and the second inner spacers 235. Nitrogen build-up areas may not be formed along the boundaries between the second inner gates (INT1_GS2, INT2_GS2, and INT3_GS2) and the second sheet patterns NS2.

If N is built up on the surfaces of the second sheet patterns NS2, the built-up N may degrade the operation characteristics of PMOS transistors. However, as no N is built up at the boundaries between the second inner gates (INT1_GS2, INT2_GS2, and INT3_GS2) and the second sheet patterns NS2, the performance degradation of PMOS transistors may be prevented.

A source/drain etch stop film 185 may be disposed on the sidewalls of the first gate spacers 140 and on the upper surfaces of the first source/drain patterns 150. The source/drain etch stop film 185 may be disposed on the sidewalls of the second gate spacers 240 and on the upper surfaces of the second source/drain patterns 250. The source/drain etch stop film 185 may be disposed on the upper surface of the field insulating film 105.

The source/drain etch stop film 185 may include a material with an etch selectivity to the first interlayer insulating film 190 that will be described later. The source/drain etch stop film 185 may include, for example, at least one of SiN, SiON, SiOCN, SiBN, SiOBN, SiOC, and a combination thereof.

The first interlayer insulating film 190 may be disposed on the source/drain etch stop film 185. The first interlayer insulating film 190 may be disposed on the first source/drain patterns 150 and the second source/drain patterns 250. The first interlayer insulating film 190 may not cover the upper surfaces of the first gate capping patterns 145 and the upper surfaces of the second gate capping patterns 245.

The first interlayer insulating film 190 may include, for example, at least one of silicon oxide, silicon nitride, silicon oxynitride, and a low-k material. The low-k material may include, for example, Fluorinated TetraEthylOrthoSilicate (FTEOS), Hydrogen SilsesQuioxane (HSQ), Bis-benzoCycloButene (BCB), TetraMethylOrthoSilicate (TMOS), OctaMethylCycloTetraSiloxane (OMCTS), HexaMethylDiSiloxane (HMDS), TriMethylSilyl Borate (TMSB), DiAcetoxyDitertiaryButoSiloxane (DADBS), TriMethylSilil Phosphate (TMSP), PolyTetraFluoroEthylene (PTFE), Tonen SilaZen (TOSZ), Fluoride Silicate Glass (FSG), polyimide nanofoam such as polypropylene oxide, Carbon Doped silicon Oxide (CDO), Organo Silicate Glass (OSG), SiLK, Amorphous Fluorinated Carbon, silica aerogel, silica xerogel, mesoporous silica, or a combination thereof, but embodiments are not limited thereto.

First source/drain contacts 180 may be disposed on the first source/drain patterns 150. The first source/drain contacts 180 may be connected to the first source/drain patterns 150. The first source/drain contacts 180 may be connected to the first source/drain patterns 150 through the first interlayer insulating film 190 and the source/drain etch stop film 185.

Second source/drain contacts 280 may be disposed on the second source/drain patterns 250. The second source/drain contacts 280 may be connected to the second source/drain patterns 250.

A first metal silicide layer 155 may be further disposed between the first source/drain contacts 180 and the first source/drain patterns 150. A second metal silicide layer 255 may be further disposed between the second source/drain contacts 280 and the second source/drain patterns 250.

The first source/drain contacts 180 and the second source/drain contacts 280 are illustrated as being single films, but embodiments are not limited thereto. The first source/drain contacts 180 and the second source/drain contacts 280 may include, for example, at least one of a metal, a conductive metal nitride, a conductive metal carbide, a conductive metal oxide, a conductive metal carbonitride, and a 2D material. The 2D material may be a metallic material and/or a semiconductor material. The 2D material may include a 2D allotrope or compound, for example, at least one of graphene, molybdenum disulfide (MoS₂), molybdenum diselenide (MoSe₂), tungsten selenide (WSe₂), and tantalum disulfide (WS₂), but embodiments are not limited thereto. That is, these 2D materials are merely example, and thus, embodiments are not limited thereto.

The first and second metal silicide films 155 and 255 may include a metal silicide.

A second interlayer insulating film 191 may be disposed on the first interlayer insulating film 190. The second interlayer insulating film 191 may include, for example, at least one of silicon oxide, silicon nitride, silicon oxynitride, and a low-k material.

A wiring structure 205 may be disposed within the second interlayer insulating film 191. The wiring structure 205 may be connected to both the first source/drain contacts 180 and the second source/drain contacts 280. The wiring structure 205 may include wiring lines and wiring vias 206.

The wiring lines 207 and the wiring vias 206 are illustrated as being distinct from each other, but embodiments are not limited thereto. That is, for example, the wiring vias 206 may be formed, and the wiring lines 207 may be formed. In another example, the wiring vias 206 and the wiring lines 207 may be formed at the same time.

The wiring lines 207 and the wiring vias 206 are illustrated as being single films, but embodiments are not limited thereto. The wiring lines 207 and the wiring vias 206 may include, for example, at least one of a metal, a conductive metal nitride, a conductive metal carbide, a conductive metal oxide, a conductive metal carbonitride, and a 2D material.

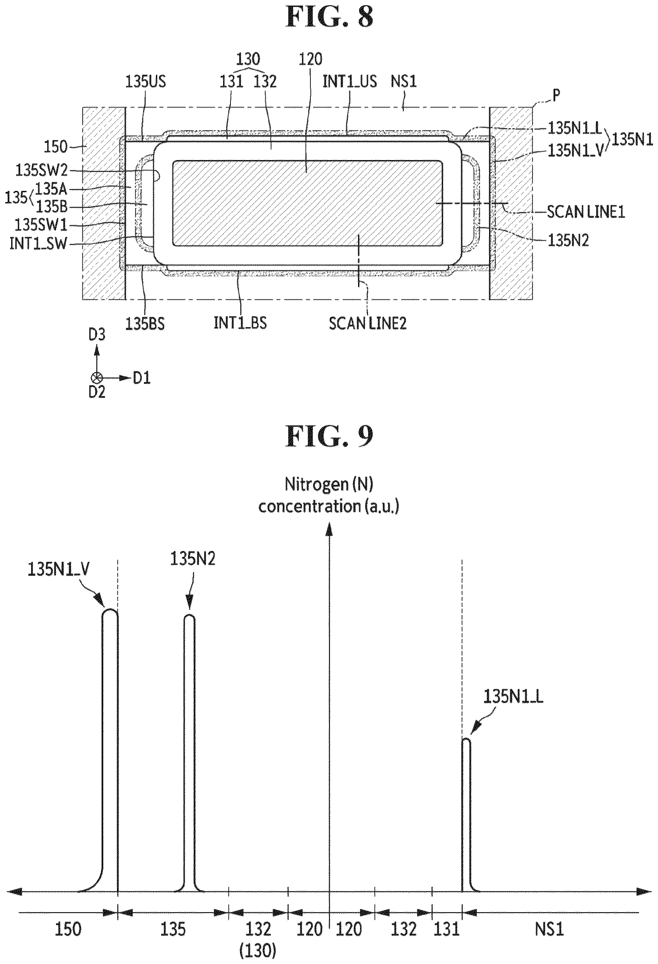

FIG. 8 is a diagram illustrating a semiconductor device according to one or more embodiments. FIG. 9 is a graph illustrating the concentration of nitrogen (N) along "SCAN LINE 1" and "SCAN LINE 2" of FIG. 8 according to one or more embodiments. For convenience, the embodiments of FIGS. 8 and 9 will hereinafter be described, focusing on differences from what has been described with reference to FIGS. 1 through 7, and repeated descriptions of the same or similar aspects above may be omitted.

Specifically, FIG. 8 is an enlarged cross-sectional view of an example that may correspond to portion P of FIG. 2, and FIG. 9 is a graph showing the concentration of N along "SCAN LINE 1" and "SCAN LINE 2" of FIG. 8.

Referring to FIGS. 8 and 9, the semiconductor device according to one or more embodiments may further include second nitrogen build-up areas 135N2, which are disposed within first inner spacers 135.

The second nitrogen build-up areas 135N2 may be areas within the first inner spacers 135 where N is built up. The second nitrogen build-up areas 135N2 may extend along sidewalls INT1_SW of first inner gates (INT1_GS1, INT2_GS1, and INT3_GS1). The second nitrogen build-up areas 135N2 may have a bracket shape (e.g., '[' or'(' shape), but embodiments are not limited thereto.

The second nitrogen build-up areas 135N2 may be spaced apart from first nitrogen build-up areas 135N1. The second nitrogen build-up areas 135N2 may be disposed within the regions defined by the first nitrogen build-up areas 135N1.

The second nitrogen build-up areas 135N2 may be spaced apart from horizontal portions 135N1_L of the first nitrogen build-up areas 135N1 in a third direction D3. The second nitrogen build-up areas 135N2 may be spaced apart from vertical portions 135N1_V of the first nitrogen build-up areas 135N1 in a first direction D1. The second nitrogen build-up areas 135N2 may be closer than the vertical portions 135N1_V of the first nitrogen build-up areas 135N1 to first gate electrodes 120.

In FIG. 9, the concentration of N is shown to be higher in the vertical portions 135N1_V of the first nitrogen build-up areas 135N1 than in the second nitrogen build-up areas 135N2, but embodiments are not limited thereto.

The first inner spacers 135 may include first sub-spacer patterns 135A and second sub-spacer patterns 135B. The first sub-spacer patterns 135A may be disposed between the second sub-spacer patterns 135B and first source/drain patterns 150. The first sub-spacer patterns 135A and the second sub-spacer patterns 135B may be divided by the second nitrogen build-up areas 135N2.

The first sub-spacer patterns 135A may include silicon oxide. The second sub-spacer patterns 135B may also include silicon oxide, but embodiments are not limited thereto.

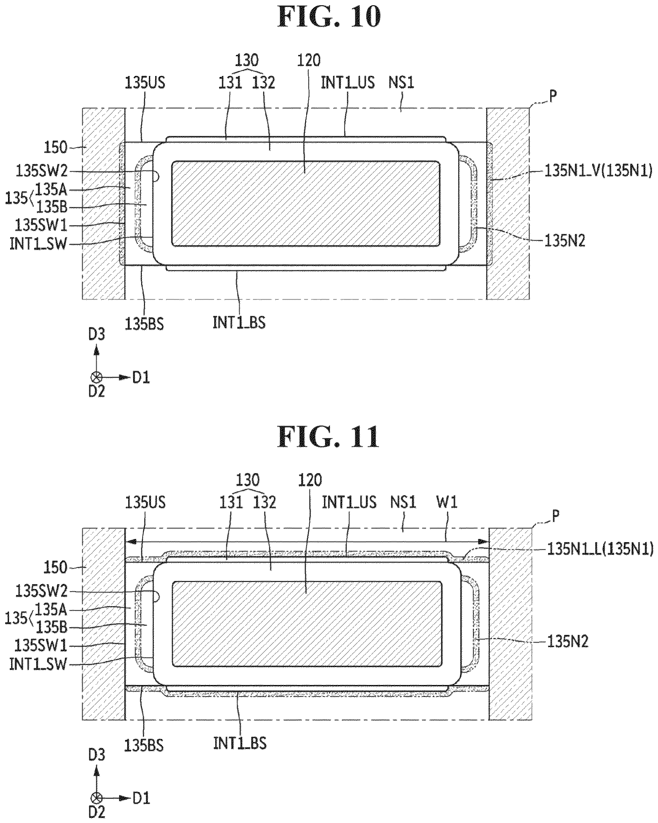

FIGS. 10 and 11 are diagrams illustrating semiconductor devices according to one or more embodiments. For convenience, the embodiments of FIGS. 10 and 11 will hereinafter be described, focusing mainly on differences from what has been described with reference to FIGS. 1 through 9, and repeated descriptions of the same or similar aspects above may be omitted.

Specifically, FIGS. 10 and 11 are enlarged cross-sectional views of an example that may correspond to portion P of FIG. 2.

Referring to FIG. 10, first nitrogen build-up areas 135N1 may not be disposed along the boundaries of first inner gates (INT1_GS1, INT2_GS1, and INT3_GS1) and first sheet patterns NS1.

The first nitrogen build-up areas 135N1 may not be formed along first surfaces INT1_US of the first inner gates (INT1_GS1, INT2_GS1, and INT3_GS1) and may not be formed along first surfaces 135US of first inner spacers 135. The first nitrogen build-up areas NS1 may not be formed along second surfaces INT1_BS of the first inner gates (INT1_GS1, INT2_GS1, and INT3_GS1) and may not be formed along second surfaces 135BS of the first inner spacers 135.

The first nitrogen build-up areas 135N1 may include vertical portions 135N1_V, and may not include horizontal portions (e.g., horizontal portions 135N1_L). Second nitrogen build-up areas 135N2 may be disposed within the first inner spacers 135.

Referring to FIG. 11, first nitrogen build-up areas 135N1 may not be disposed along the boundaries between first source/drain patterns 150 and first inner spacers 135.

The first nitrogen build-up areas 135N1 may not be formed along first sidewalls 135SW1 of the first inner spacers 135.

The first nitrogen build-up areas 135N1 may include horizontal portions 135N1_L and may not include vertical portions (e.g., vertical portions 135N1_V). Second nitrogen build-up areas 135N2 may be disposed within the first inner spacers 135.

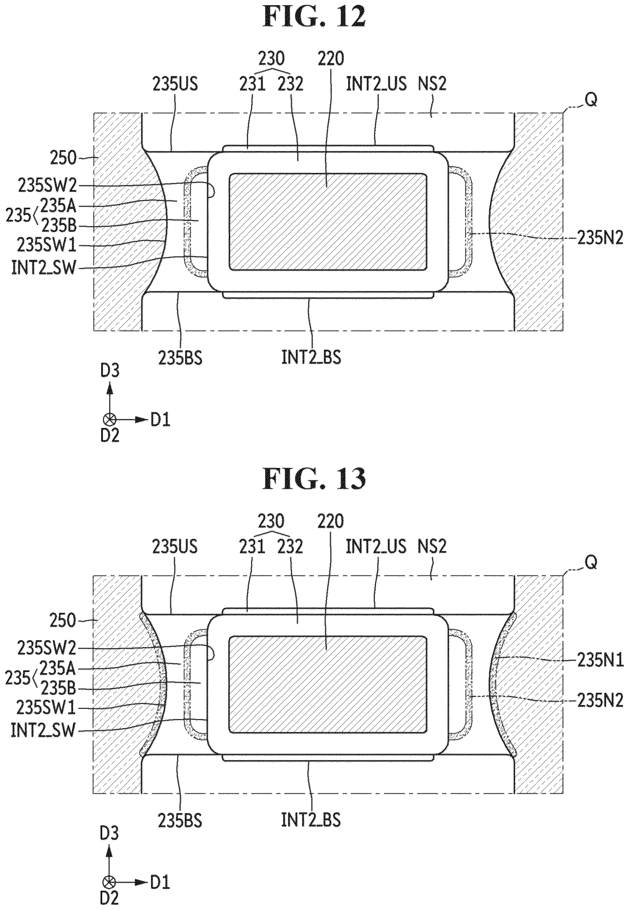

FIGS. 12 and 13 are diagrams illustrating semiconductor devices according to one or more embodiments. For convenience, the embodiments of FIGS. 12 and 13 will hereinafter be described, focusing mainly on differences from what has been described with reference to FIGS. 1 through 11, and repeated descriptions of the same or similar aspects above may be omitted.

Specifically, FIGS. 12 and 13 are enlarged cross-sectional views of an example that may correspond to portion Q of FIG. 3.

Referring to FIGS. 12 and 13, the semiconductor devices according to one or more embodiments may further include fourth nitrogen build-up areas 235N2, which are disposed within second inner spacers 235.

The fourth nitrogen build-up areas 235N2 may be areas within the second inner spacers 235 where N is built up. The fourth nitrogen build-up areas 235N2 may extend along sidewalls INT2_SW of second inner gates (INT1_GS2, INT2_GS2, and INT3_GS2). The fourth nitrogen build-up areas 235N2 may have a bracket shape (e.g., '[' or '(' shape), but embodiments are not limited thereto.

The fourth nitrogen build-up areas 235N2 may be spaced apart from second source/drain patterns 250. The fourth nitrogen build-up areas 235N2 may be spaced apart from second sheet patterns NS2 in a third direction D3.

The second inner spacers 235 may include third sub-spacer patterns 235A and fourth sub-spacer patterns 235B. The third sub-spacer patterns 235A may be disposed between the fourth sub-spacer patterns 235B and the second source/drain patterns 250. The third sub-spacer patterns 235A and the fourth sub-spacer patterns 235B may be divided by the fourth nitrogen build-up areas 235N2.

The third sub-spacer patterns 235A may include silicon oxide. The fourth sub-spacer pattern 235B may also include silicon oxide, but embodiments are not limited thereto.

In FIG. 12, nitrogen build-up areas may not be disposed along the boundaries between the second source/drain patterns 250 and the second inner spacers 235. Nitrogen build-up areas may not be formed along first sidewalls 235SW1 of the second inner spacers 235.

In FIG. 13, the semiconductor device according to one or more embodiments may further include third nitrogen build-up areas 235N1, which are disposed along the boundaries between the second source/drain patterns 250 and the second inner spacers 235.

The third nitrogen build-up areas 235N1 may extend along first sidewalls 135SW1 of first inner spacers 135. The third nitrogen build-up areas 235N1 may extend along the sidewalls INT2_SW of the second inner gates (INT1_GS2, INT2_GS2, and INT3_GS2).

Third nitrogen build-up areas 235N1 may be formed within the second source/drain patterns 250. The third nitrogen build-up areas 235N1 may be areas within the second source/drain patterns 250 where N is built up.

The third nitrogen build-up areas 235N1 may not be formed along first surfaces INT2_US of the second inner gates (INT1_GS2, INT2_GS2, and INT3_GS2) and may not be formed along the first surfaces 235US of the second inner spacers 235. The third nitrogen build-up areas 235N1 may not be formed along second surfaces INT2_BS of the second inner gates 235 and may not be formed along second surfaces 235BS of the second inner spacers 235.

The fourth nitrogen build-up areas 235N2 may be spaced apart from the third nitrogen build-up areas 235N1 in a first direction D1. The fourth nitrogen build-up areas 235N2 may be closer than the third nitrogen build-up areas 235N1 to second gate electrodes 220.

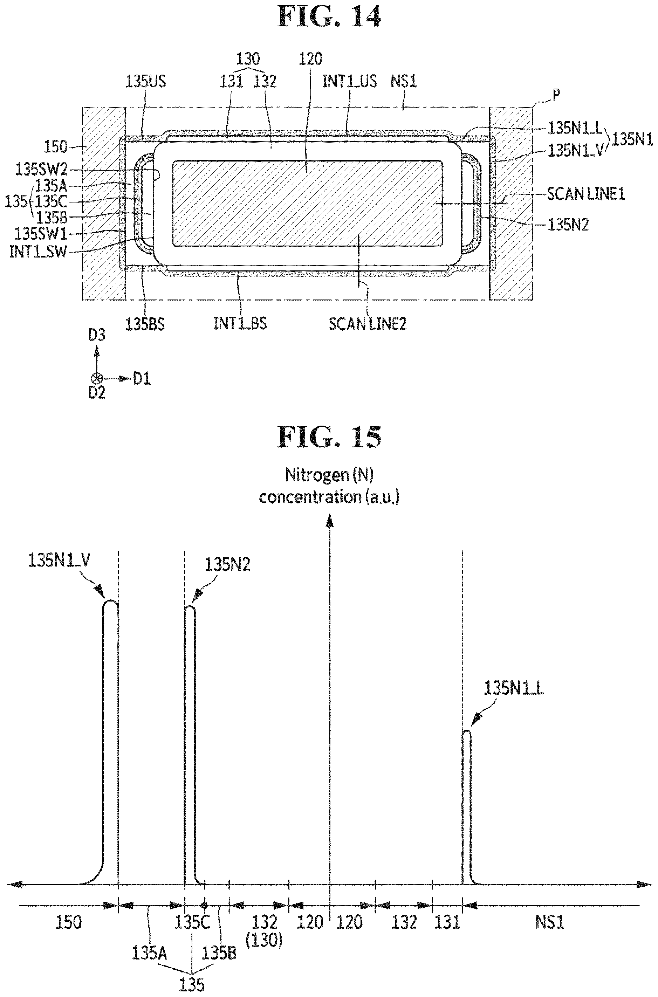

FIG. 14 is a diagram illustrating a semiconductor device according to one or more embodiments. FIG. 15 is a graph illustrating the concentration of nitrogen (N) along "SCAN LINE 1" and "SCAN LINE 2" of FIG. 14 according to one or more embodiments. For convenience, the embodiment of FIGS. 14 and 15 will hereinafter be described, focusing mainly on differences from what has been described with reference to FIGS. 1 through 13, and repeated descriptions of the same or similar aspects above may be omitted.

Specifically, FIG. 14 is an enlarged cross-sectional view of an example that may correspond to portion P of FIG. 2, and FIG. 15 is a graph showing the concentration of N along "SCAN LINE 1" and "SCAN LINE 2" of FIG. 14.

The following description of first inner spacers 135 may be directly applicable to the second inner spacers 235 of FIGS. 12 and 13.

Referring to FIGS. 14 and 15, the first inner spacers 135 may further include fifth sub-spacer patterns 135C.

The fifth sub-spacer patterns 135C may be disposed between first sub-spacer patterns 135A and second sub-spacer patterns 135B. The first sub-spacer patterns 135A may be disposed between the fifth sub-spacer patterns 135C and first source/drain patterns 150. The fifth sub-spacer patterns 135C may separate the first sub-spacer patterns 135A and the second sub-spacer patterns 135B.

The fifth sub-spacer patterns 135C may include a different material from the first sub-spacer patterns 135A and the second sub-spacer patterns 135B. The fifth sub-spacer patterns 135C may include, for example, polycrystalline silicon.

When second nitrogen build-up areas 135N2 are disposed within the first inner spacers 135, the second nitrogen build-up areas 135N2 may be disposed within the fifth sub-spacer patterns 135C. The second nitrogen build-up areas 135N2 may be areas within the fifth sub-spacer patterns 135C where N is built up.

For example, the second nitrogen build-up areas 135N2 may extend along the boundaries between the first sub-spacer patterns 135A and the fifth sub-spacer patterns 135C. If the thickness of the fifth sub-spacer pattern 135C is sufficient, the second nitrogen build-up areas 135N2 may be formed closer to the boundaries between the first sub-spacer patterns 135A and the fifth sub-spacer patterns 135C than to the boundaries between the third sub-spacer patterns 135B and the fifth sub-spacer patterns 135C.

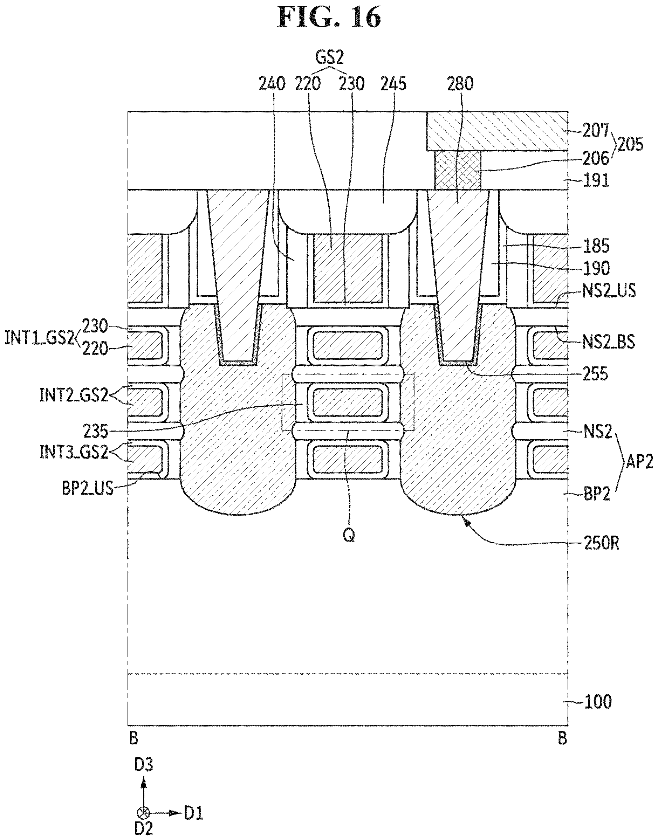

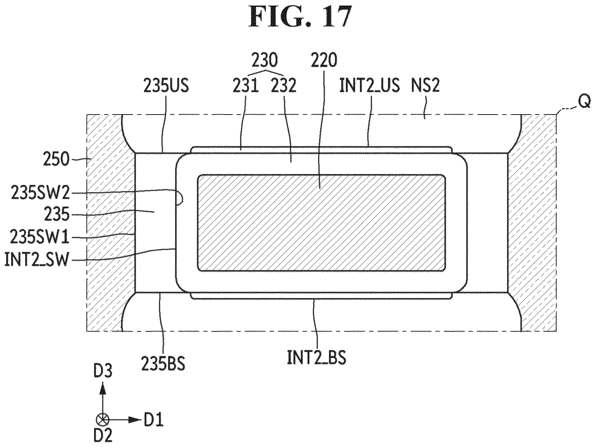

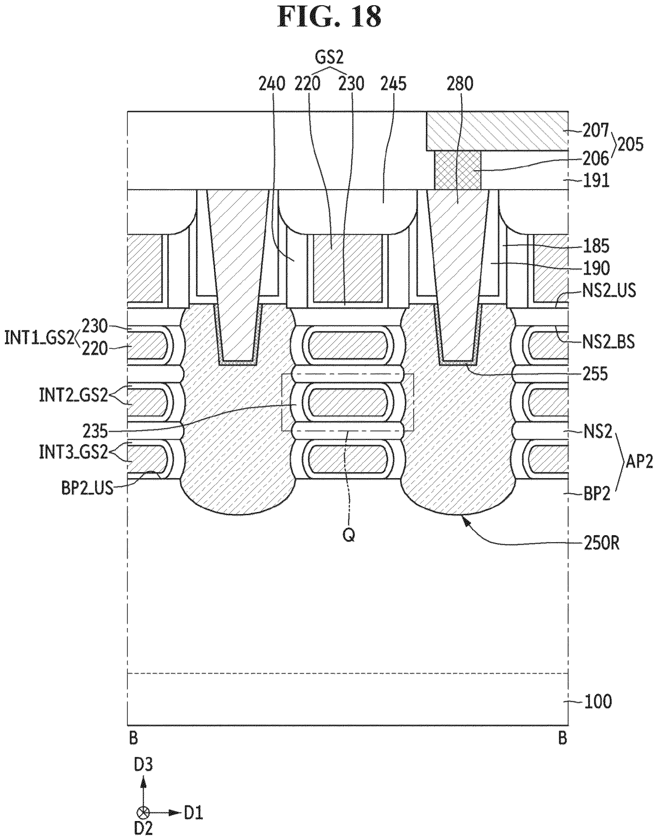

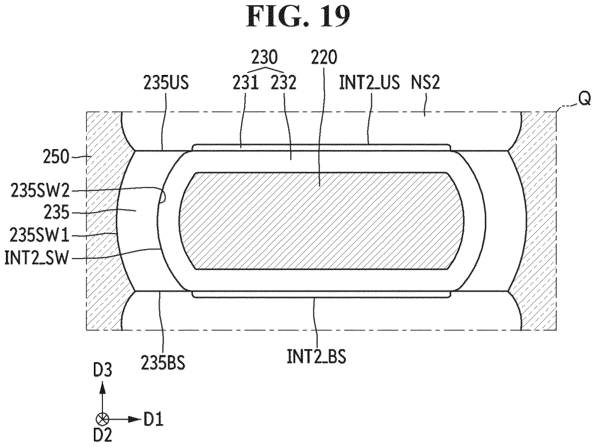

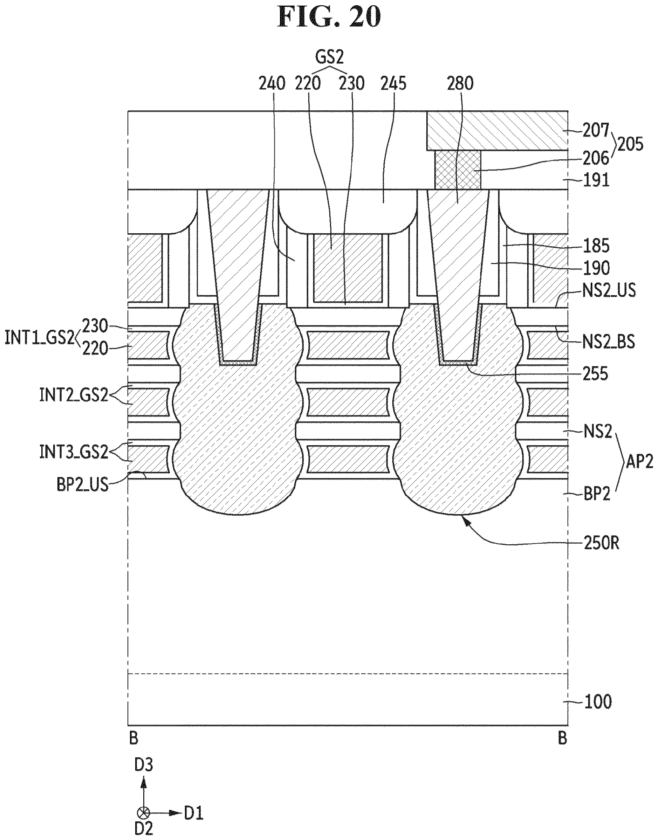

FIGS. 16 and 17 are diagrams illustrating a semiconductor device according to one or more embodiments. FIGS. 18 and 19 are diagrams illustrating a semiconductor device according to one or more embodiments. FIG. 20 is a diagram illustrating a semiconductor device according to one or more embodiments. For convenience, the embodiments of FIGS. 16 through 20 will hereinafter be described, focusing mainly on differences from what has been described with reference to FIGS. 1 through 15, and repeated descriptions of the same or similar aspects above may be omitted.

Specifically, FIGS. 17 and 19 are enlarged cross-sectional views of examples that may correspond to portion Q of FIGS. 16 and 18, respectively.

Referring to FIGS. 16 and 17, first sidewalls 235SW1 of second inner spacers 235 may be flat.

The second sidewalls 235SW2 of the second inner spacers 235 are illustrated as having a concave shape, but embodiments are not limited thereto.

Referring to FIGS. 18 and 19, first sidewalls 235SW1 of second inner spacers 235 may have a convex shape.

Second sidewalls 235SW2 of the second inner spacers 235 may have a concave shape.

Referring to FIG. 20, second source/drain patterns 250 may contact second inner gates (INT1_GS2, INT2_GS2, and INT3_GS2).

The second source/drain patterns 250 may contact a second gate insulating film 230 included in the second inner gates (INT1_GS2, INT2_GS2, and INT3_GS2). The second inner spacers 235 may not be disposed between the second source/drain patterns 250 and the second inner gates (INT1_GS2, INT2_GS2, and INT3_GS2).

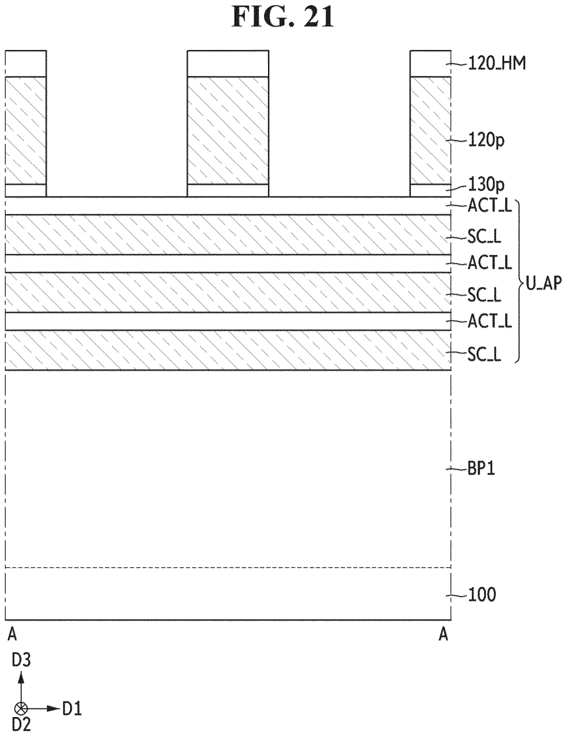

FIGS. 21 through 39 are diagrams illustrating operations of a method of fabricating a semiconductor device according to one or more embodiments.

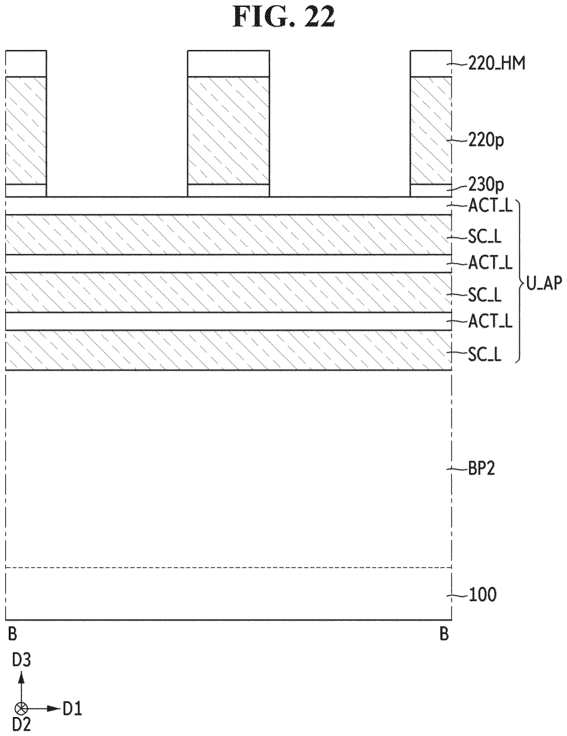

Referring to FIGS. 21 and 22, a first lower pattern BP1 and an upper pattern structure U_AP may be formed on a substrate 100.

A second lower pattern BP2 and an upper pattern structure U_AP may be formed on the substrate 100.

The first and second lower patterns BP1 and BP2 may extend in a first direction D1. The upper pattern structure U_AP may be disposed on both the first and second lower patterns BP1 and BP2.

The upper pattern structure U_AP may include sacrificial patterns SC_L and active patterns ACT_L, which are stacked alternating the sacrificial patterns SC_L. The sacrificial patterns SC_L and the active patterns ACT_L may be alternately stacked on each of the first and second lower patterns BP1 and BP2.

For example, the sacrificial patterns SC_L may include a SiGe film. The active patterns ACT_L may include a Si layer.

Thereafter, a first dummy gate structure, which extends in a second direction D2, may be formed on the first lower pattern BP1 and the upper pattern structure U_AP. A second dummy gate structure, which extends in the second direction D2, may be formed on the second lower pattern BP2 and the upper pattern structure U_AP.

The first dummy gate structure may include a first dummy gate insulating film 130p, a first dummy gate electrode 120p, and a first dummy gate capping film 120_HM. The second dummy gate structure may include a second dummy gate insulating film 230p, second dummy gate electrodes 220p, and a second dummy gate capping film 220_HM.

The first and second dummy gate insulating films 130p and 230p may include, for example, silicon oxide, but embodiments are not limited thereto. The first dummy gate electrodes 120p and the second dummy gate electrodes 220p may include, for example, polysilicon, but embodiments are not limited thereto. The first and second dummy gate capping films 120_HM and 220_HM may include, for example, silicon nitride, but embodiments are not limited thereto.

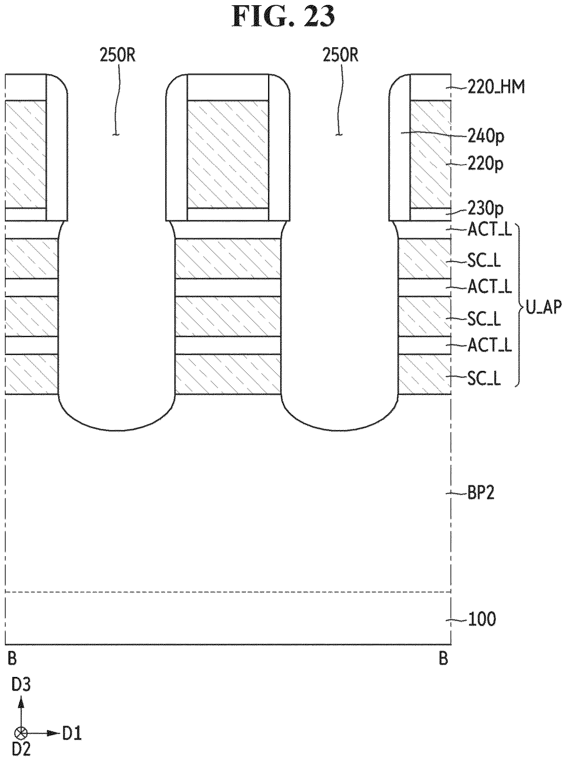

Referring to FIGS. 23 and 24, second pre-gate spacers 240p may be formed on the sidewalls of the second dummy gate electrodes 220p.

Using the second dummy gate electrodes 220p and the second pre-gate spacers 240p as a mask, second source/drain recesses 250R may be formed within the upper pattern structure U_AP.

Portions of the second source/drain recesses 250R may be formed within the second lower pattern BP2. The lower surfaces of the second source/drain recesses 250R may be defined by the second lower pattern BP2.

After the formation of the second source/drain recesses 250R, as illustrated in FIG. 23, the sacrificial patterns SC_L may be additionally etched. Consequently, width expansion areas 250R_ER of the second source/drain recesses 250R may be formed.

The second source/drain recesses 250R may include a plurality of width expansion areas 250R_ER. The sidewalls of the second source/drain recesses 250R may have a wavy form. However, the fabrication of the second source/drain recesses 250R that include a plurality of width expansion areas 250R_ER is not limited to that described above.

Subsequent steps of the method of fabricating a semiconductor device according to one or more embodiments may be performed after the step of forming the width expansion areas 250R_ER, as illustrated in FIG. 24. Alternatively, the subsequent steps of the method of fabricating a semiconductor device according to one or more embodiments may be performed after the step of forming the second source/drain recesses 250R, as illustrated in FIG. 23.

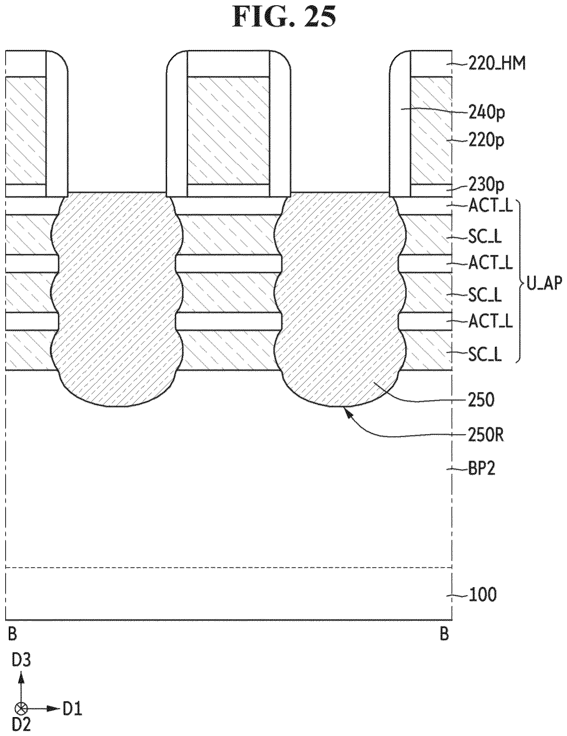

Referring to FIG. 25, second source/drain patterns 250 may be formed on the second lower pattern BP2.

The second source/drain patterns 250 may be formed within the second source/drain recesses 250R. The second source/drain patterns 250 may fill the second source/drain recesses 250R.

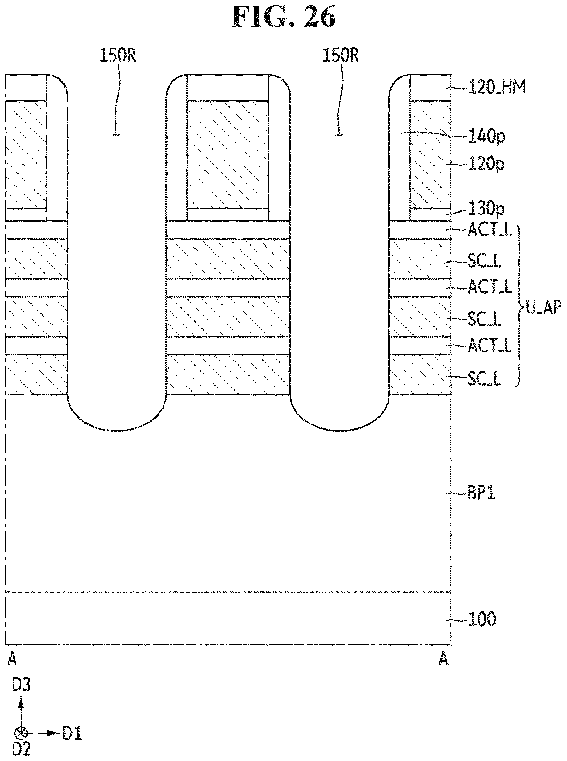

Referring to FIG. 26, first pre-gate spacers 140p may be formed on the sidewalls of the first dummy gate electrodes 120p.

Using the first dummy gate electrodes 120p and the first pre-gate spacers 140p as a mask, first source/drain recesses 150R may be formed within the upper pattern structure U AP.

Portions of the first source/drain recesses 150R may be formed within the first lower pattern BP1. The lower surfaces of the first source/drain recesses 150R may be defined by the first lower pattern BP1.

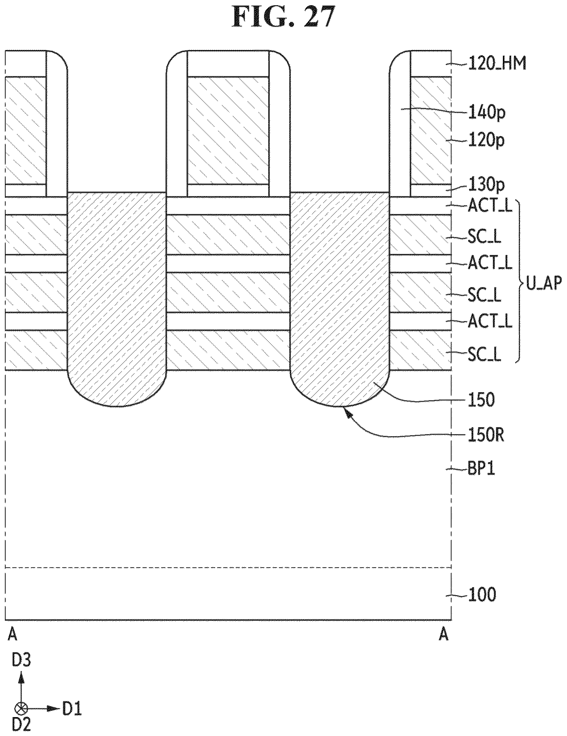

Referring to FIG. 27, first source/drain patterns 150 may be formed on the first lower pattern BP1.

The first source/drain patterns 150 may be formed within the first source/drain recesses 150R. The first source/drain patterns 150 may fill the first source/drain recesses 150R.

Alternatively, the first source/drain patterns 150 may be formed first, and then the second source/drain patterns 250 may be formed.

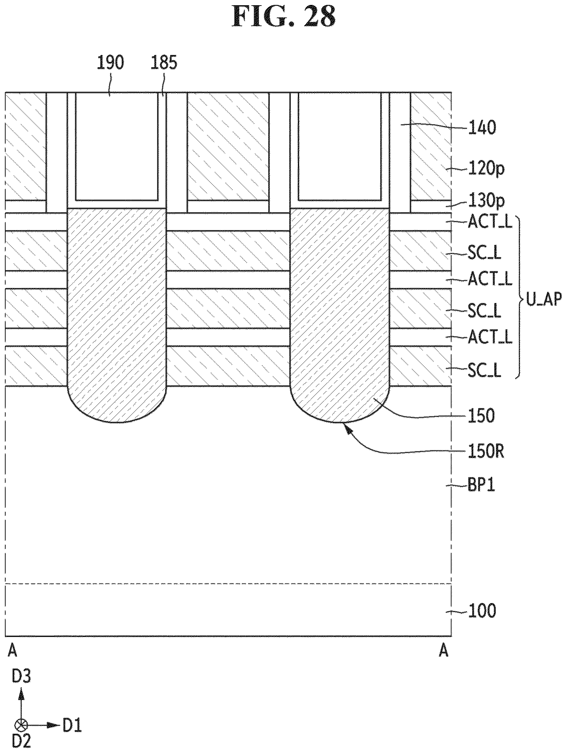

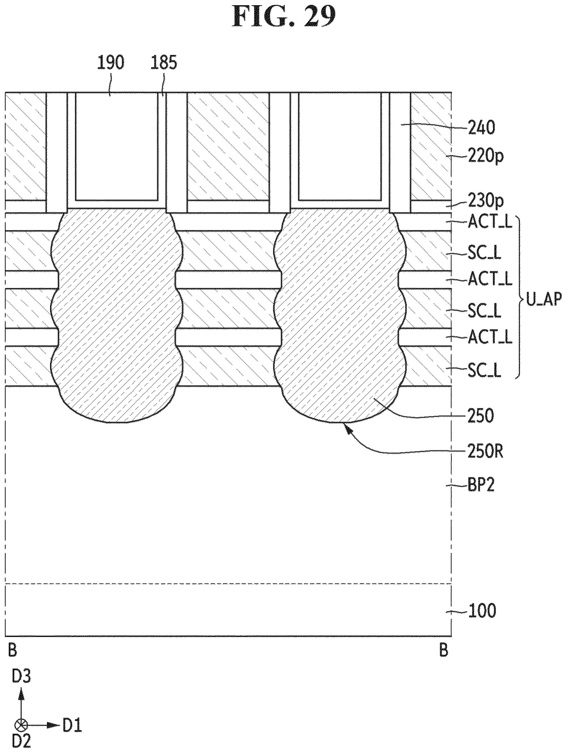

Referring to FIGS. 28 and 29, a source/drain etch stop film 185 and a first interlayer insulating film 190 may be formed on the first source/drain patterns 150 and the second source/drain patterns 250.

Thereafter, the upper surfaces of the first dummy gate electrodes 120p and the upper surfaces of the second dummy gate electrodes 220p may be exposed by removing portions of the first interlayer insulating film 190, and by removing portions of the source/drain etch stop film 185, the first dummy gate capping film 120_HM, and the second dummy gate capping film 220_HM. During the exposure of the upper surfaces of the first dummy gate electrodes 120p and the upper surfaces of the second dummy gate electrodes 220p, first gate spacers 140 and second gate spacers 240 may be formed.

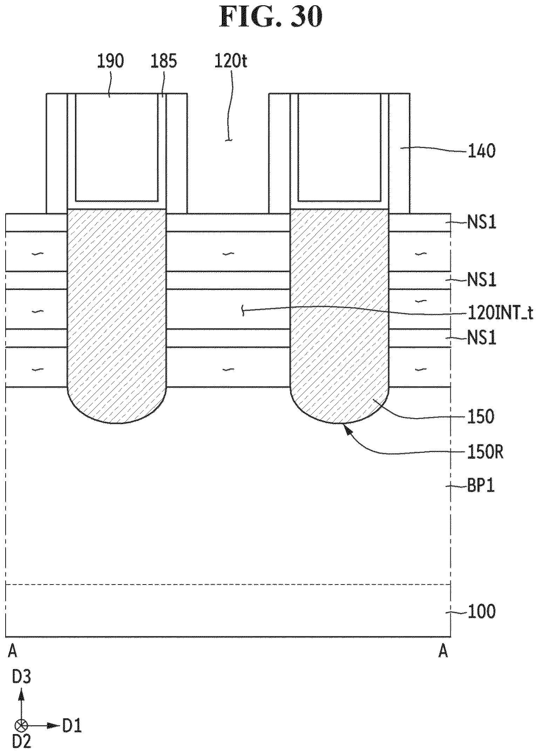

The formation of first inner spacers ("135" of FIG. 2) will hereinafter be described with reference to FIGS. 30 through 37. For example, during the formation of the first inner spacers 135 in a first region I, second inner spacers ("235" of FIG. 3) may also be formed in a second region II. Alternatively, the first inner spacers 124 may be formed in the first region I, and then, the second inner spacers 235 may be formed in the second region II using the method that will hereinafter be described with reference to FIGS. 30 through 37.

Referring to FIG. 30, the upper pattern structure U_AP may be exposed between the first gate spacers 140 by removing the first dummy gate insulating film 130p and the first dummy gate electrodes 120p.

Thereafter, first sheet patterns NS1 may be formed by removing the sacrificial patterns SC_L. The first sheet patterns NS1 may be connected to the first source/drain patterns 150. Consequently, a first active pattern ("AP1" of FIG. 2), including the first lower pattern BP1 and the first sheet patterns NS1, may be formed.

Furthermore, gate trenches 120t may be formed between the first gate spacers 140 by removing the sacrificial patterns SC_L. As a result of the removal of the sacrificial patterns SC_L, portions of the first source/drain patterns 150 may be exposed.

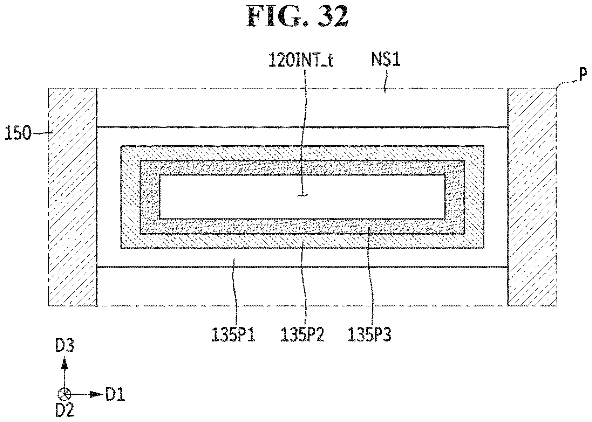

The gate trenches 120t may include multiple inner gate trenches 120INT_t. The inner gate trenches 120INT_t may be defined between each pair of adjacent first sheet patterns NS1 in the third direction D3, and between the first lower pattern BP1 and the lowermost one of the first sheet patterns NS 1. In a cross-sectional view, the inner gate trenches 120INT_t may expose portions of the first source/drain patterns 150. Referring to FIG. 32, the inner gate trenches 120INT_t may be defined by the first sheet patterns NS1 and the first source/drain patterns 150. The inner gate trenches 120INT_t may be defined by the first lower pattern BP1, the first sheet patterns NS1, and the first source/drain patterns 150.

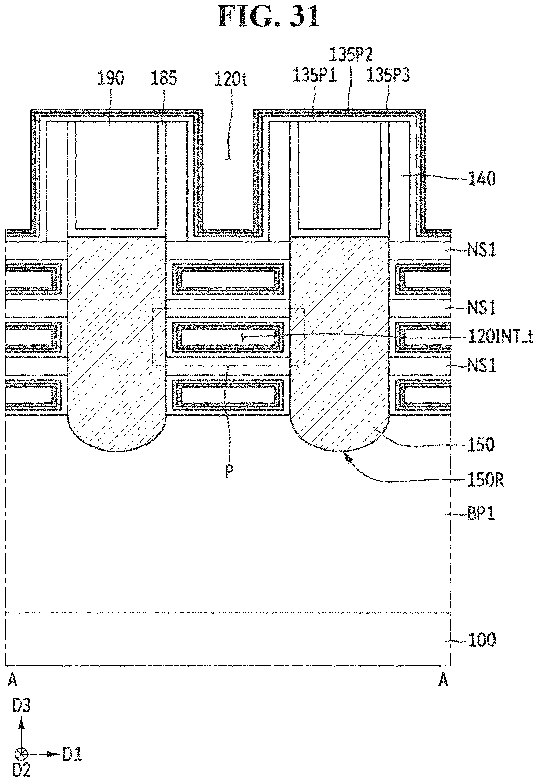

Referring to FIGS. 31 and 32, first, second, and third inner spacer material layers 135P1, 135P2, and 135P3 may be formed within the gate trenches 120t.

The first inner spacer material layer 135P1 may extend along the sidewalls of the first gate spacers 140 and the upper surface of the first interlayer insulating film 190. The first inner spacer material layer 135P1 may be formed along both the upper and lower surfaces of each of the first sheet patterns NS1 and the first source/drain patterns 150, exposed by the inner gate trenches 120INT_t.

The first inner spacer material layer 135P1 may be formed using, for example, atomic layer deposition (ALD). The first inner spacer material layer 135P1 may include, for example, silicon oxide.

Within the inner gate trenches 120INT_t where the first inner spacer material layer 135P1 is formed, the thickness of the first inner spacer material layer 135P1 may be less on the surfaces of the first sheet pattern NS1 than on the first source/drain patterns 150. In a cross-sectional view, the length of the first sheet patterns NS1, exposed by the inner gate trenches 120INT_t, may be greater than the length of the first source/drain patterns 150, exposed by the inner gate trenches 120INT_t. Due to these geometric differences, the thickness of the first inner spacer material layer 135P1 on the surfaces of the first sheet patterns NS1 may differ from the thickness of the first inner spacer material layer 135P1 on the first source/drain patterns 150.

Referring again to FIGS. 5 and 6, the length W1, in the first direction D1, of the first sheet patterns NS1 may be greater than or equal to the length W2, in the first direction D1, of the second sheet patterns NS2. In one or more embodiments, the length W1 of the first sheet patterns NS1 is greater than the length W2 of the second sheet patterns NS2. If the first inner spacer material layer 135P1 is simultaneously formed in both the first and second areas I and II, the first inner spacer material layer 135P1 may be thinner on the first sheet patterns NS1 than on the second sheet patterns NS2. Due to the length of the first sheet patterns NS1 and the length of the second sheet patterns NS2, the thickness of the first inner spacer material layer 135P1 may be less on the first source/drain patterns 150 than on the second source/drain patterns 250.

The second inner spacer material layer 135P2 may be formed on the first inner spacer material layer 135P1. The second inner spacer material layer 135P2 may be formed along the profile of the first inner spacer material layer 135P1.

The second inner spacer material layer 135P2 may be formed using, for example, ALD. The second inner spacer material layer 135P2 may include, for example, polycrystalline silicon, but embodiments are not limited thereto. The second inner spacer material layer 135P2 may include, for example, one of polycrystalline SiGe, polycrystalline Ge, amorphous Si, amorphous SiGe, and amorphous Ge.

Within the inner gate trenches 120INT_t where the second inner spacer material layer 135P2 is formed, the thickness of the second inner spacer material layer 135P2 may be less on the surfaces of the first sheet patterns NS1 than on the first source/drain patterns 150.

Similarly to what has been described in connection with the first inner spacer material layer 135P1, if the second inner spacer material layer 135P2 is simultaneously formed in both the first and second areas I and II, the second inner spacer material layer 135P2 may be thinner on the first sheet patterns NS1 than on the second sheet patterns NS2. Furthermore, the thickness of the second inner spacer material layer 135P2 may be less on the first source/drain patterns 150 than on the second source/drain patterns 250.

The third inner spacer material layer 135P3 may be formed on the second inner spacer material layer 135P2. The third inner spacer material layer 135P3 may be formed along the profile of the second inner spacer material layer 135P2.

The third inner spacer material layer 135P3 may be formed using, for example, ALD. The third inner spacer material layer 135P3 may include, for example, an insulating material containing Si and N. For example, the third inner spacer material layer 135P3 may include at least one of SiN, SiON, SiOCN, or SiCN, but embodiments are not limited thereto.

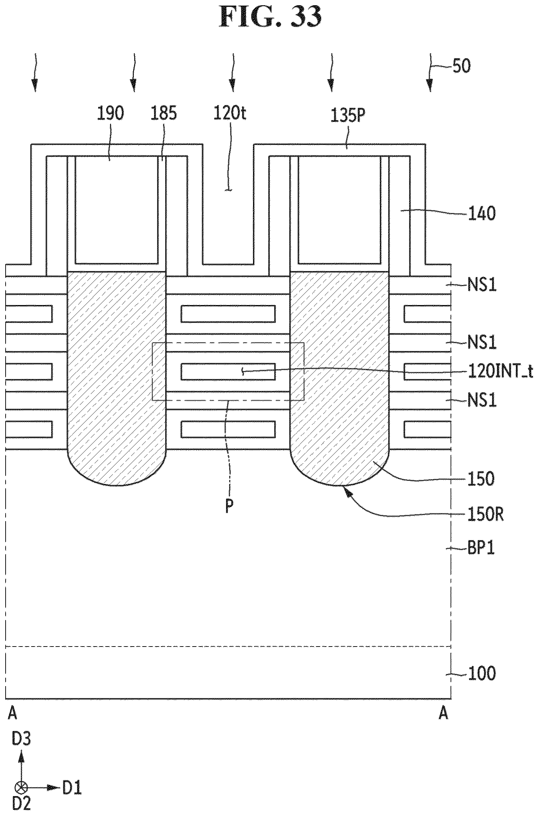

Referring to FIGS. 33 through 35, the second and third inner spacer material layers 135P2 and 135P3 may be oxidized using an oxidation process 50.

Consequently, a pre-inner spacer material layer 135P may be formed along the sidewalls of the first gate spacer 140 and the upper surface of the first interlayer insulating film 190. The pre-inner spacer material layer 135P may be formed along both the upper and lower surfaces of each of the first sheet patterns NS1 and the first source/drain patterns 150, exposed by the inner gate trenches 120INT_t. The pre-inner spacer material layer 135P may include the first inner spacer material layer 135P1 of FIGS. 31 and 32, the oxidized second inner spacer material layer 135P2 of FIGS. 31 and 32, and the oxidized third inner spacer material layer 135P3 of FIGS. 31 and 32.

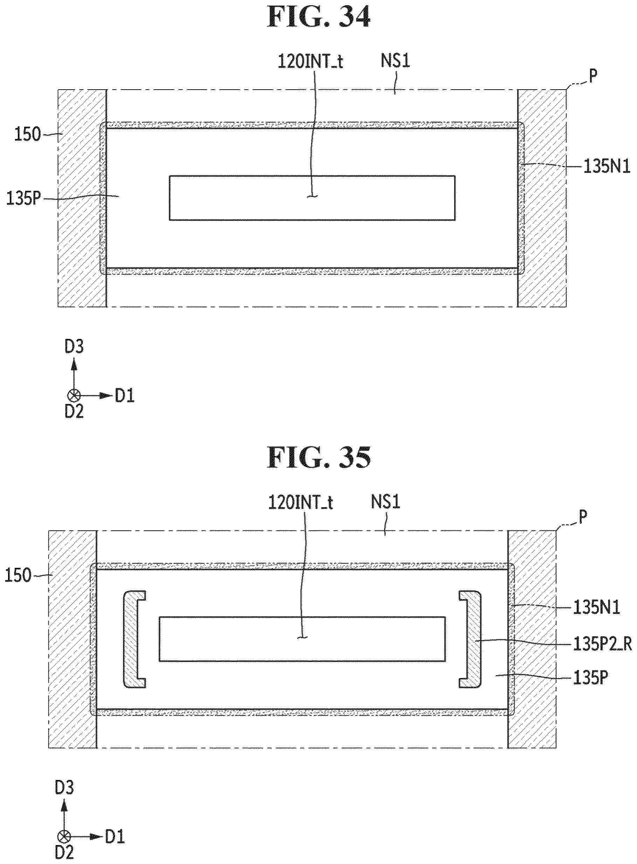

Referring to FIG. 34, the second and third inner spacer material layers 135P2 and 135P3 may be generally oxidized.

Referring to FIG. 35, the third inner spacer material layer 135P3 may be oxidized, but portions of the second inner spacer material layer 135P2 may be unoxidized. The unoxidized portions of the second inner spacer material layer 135P2 may remain within the pre-inner spacer material layer 135P as a residual spacer material layer 135P2_R.

Due to the geometric differences described above with reference to FIGS. 32 and 33, the thickness of oxidized portions on the surfaces of the first sheet patterns NS1 may differ from the thickness of oxidized portions on the first source/drain patterns 150. The thickness of the oxidized portions of the second and third inner spacer material layers 135P2 and 135P3 on the surfaces of the first sheet patterns NS1 may be less than the thickness of the oxidized portions of the second and third inner spacer material layers 135P2 and 135P3.

As the second and third inner spacer material layers 135P2 and 135P3 are oxidized, N included in the third inner spacer material layer 135P3 may diffuse toward the first sheet patterns NS1 and the first source/drain patterns 150. Consequently, first nitrogen build-up areas 135N1 may be formed.

Second nitrogen build-up areas ("135N2" of FIG. 9) may be formed within the pre-inner spacer material layer 135P of FIG. 34 or within the residual spacer material layer 135P2 R of FIG. 35.

In FIGS. 31 and 32, the thickness of the first inner spacer material layer 135P1 may be less on the first sheet patterns NS 1 than on the second sheet patterns NS2. The thickness of the second inner spacer material layer 135P2 may be less on the first sheet patterns NS1 than on the second sheet patterns NS2. The thickness of the first and second inner spacer material layers 135P1 and 135P2 may be greater on the second sheet patterns NS2 than on the first sheet patterns NS1. For example, as the second and third inner spacer material layers 135P2 and 135P3 are oxidized, the N included in the third inner spacer material layer 135P3 may not diffuse toward the surfaces of the second sheet patterns NS2. Alternatively, during the oxidation of the second and third inner spacer material layers 135P2 and 135P3, a lesser amount of N may diffuse toward the surfaces of the second sheet patterns NS2 than toward the surfaces of the first sheet patterns NS1.

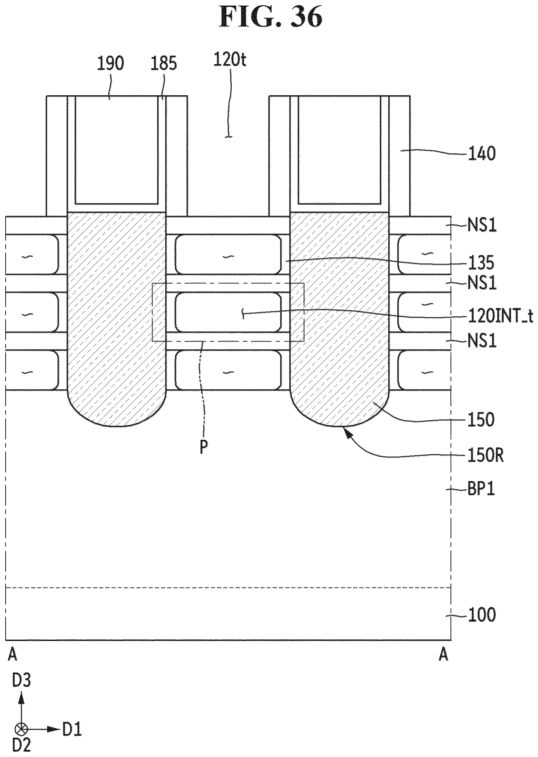

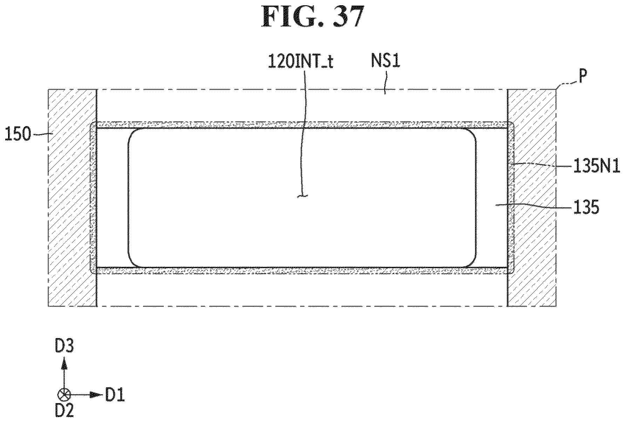

Referring to FIGS. 36 and 37, first inner spacers 135 may be formed by removing portions of the pre-inner spacer material layer 135P.

The first inner spacers 135 may be formed on the first source/drain patterns 150. The first inner spacers 135 may be formed between each pair of adjacent first sheet patterns NS1 in the third direction D3, and between the lowermost one of the first sheet patterns NS1 and the first lower pattern BP1. During the formation of the first inner spacers 135, portions of the pre-inner spacer material layer 135P on the upper and lower surfaces of each of the first sheet patterns NS1 may be removed. During the formation of the first inner spacers 135, portions of the pre-inner spacer material layer 135P on the sidewalls of the first gate spacers 140 and on the upper surface of the first interlayer insulating film 190 may be removed.

Alternatively, when the portions of the pre-inner spacer material layer 135P on the upper and lower surfaces of each of the first sheet patterns NS1 are removed, at least portions of the first nitrogen build-up areas 135N1 formed within the first sheet patterns NS1 may also be removed.

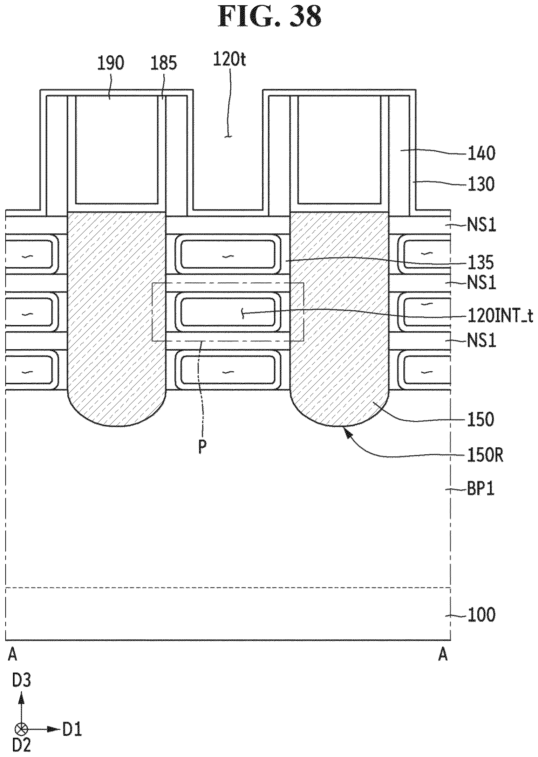

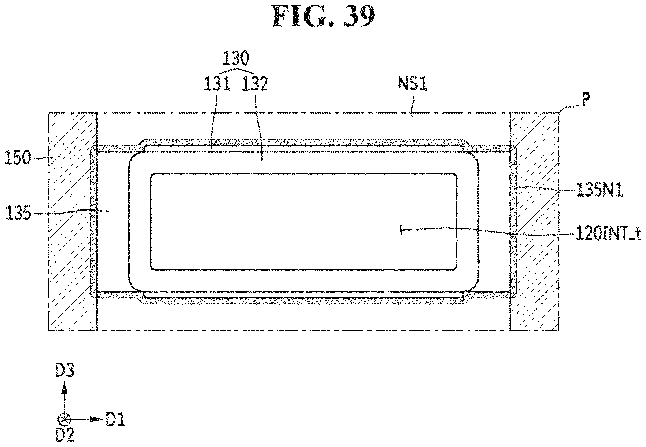

Referring to FIGS. 38 and 39, a first gate insulating film 130 may be formed along the sidewalls of the first gate spacers 140 and the upper surface of the first interlayer insulating film 190.

The first gate insulating film 130 may be formed along both the upper and lower surfaces of each of the first sheet patterns NS1 and the first inner spacers 135, exposed by the inner gate trenches 120INT_t.

During the formation of the first gate insulating film 130, the first inner spacers 135 may be exposed to an oxidation process. If the first inner spacers 135 are continuously exposed to the oxidation process, the residual spacer material layer 135P2_R of FIG. 35 may also be oxidized, turning into silicon oxide.

Thereafter, referring again to FIG. 2, first gate electrodes 120 may be formed within the gate trenches 120t and the inner gate trenches 120INT_t. Additionally, first gate capping patterns 145 may be formed.

Each of the embodiments provided in the above description is not excluded from being associated with one or more features of another example or another embodiment also provided herein or not provided herein but consistent with the disclosure.

While the disclosure has been particularly shown and described with reference to embodiments thereof, it will be understood that various changes in form and details may be made therein without departing from the spirit and scope of the following claims.

## Claims

1. A semiconductor device comprising:
a first active pattern comprising a first lower pattern and first sheet patterns spaced apart from the first lower pattern in a first direction;
a first gate structure comprising first inner gates between the first lower pattern and a lowermost first sheet pattern of the first sheet patterns, and between each pair of adjacent first sheet patterns, the first inner gates extending in a second direction that intersects the first direction, wherein each of the first inner gates comprises a first gate electrode and a first gate insulating film;
first source/drain patterns on the first lower pattern and connected to the first sheet patterns;
first inner spacers between the first source/drain patterns and the first inner gates; and
first nitrogen build-up areas within the first inner spacers,
wherein each of the first inner gates has a first surface, a second surface opposite to the first surface in the first direction, and sidewalls connecting the first surface and the second surface, and
wherein the first nitrogen build-up areas extend along the sidewalls of the first inner gates.

2. The semiconductor device of claim 1, further comprising:
second nitrogen build-up areas extending along boundaries between the first inner spacers and the first source/drain patterns.

3. The semiconductor device of claim 2, wherein the second nitrogen build-up areas comprise:
vertical portions extending along the boundaries between the first inner spacers and the first source/drain patterns; and
horizontal portions extending along the first surfaces and second surfaces of the first inner gates.

4. The semiconductor device of claim 2, wherein the second nitrogen build-up areas are not along respective boundaries between the first inner gates and the first sheet patterns.

5. The semiconductor device of claim 1, further comprising:
second nitrogen build-up areas respectively extending along boundaries between the first inner gates and the first sheet patterns,
wherein the second nitrogen build-up areas are not along respective boundaries between the first inner spacers and the first source/drain patterns.

6. The semiconductor device of claim 1, further comprising:
a second active pattern comprising a second lower pattern and second sheet patterns spaced apart from the second lower pattern in the first direction;
a second gate structure comprising second inner gates between the second lower pattern and a lowermost second sheet pattern of the second sheet patterns, and between each pair of adjacent second sheet patterns;
second source/drain patterns on the second lower pattern and connected to the second sheet patterns; and
second inner spacers between the second source/drain patterns and the second inner gates,
wherein no nitrogen build-up areas are formed along circumferences of the second inner gates.

7. The semiconductor device of claim 6, wherein, in a third direction intersecting the first direction and the second direction, a thickness of the first inner spacers is less than or equal to a thickness of the second inner spacers.

8. The semiconductor device of claim 1, further comprising:
a second active pattern comprising a second lower pattern and second sheet patterns spaced apart from the second lower pattern in the first direction;
a second gate structure comprising second inner gates between the second lower pattern and a lowermost second sheet pattern of the second sheet patterns, and between each pair of adjacent second sheet patterns;
second source/drain patterns on the second lower pattern and connected to the second sheet patterns;
second inner spacers between the second source/drain patterns and the second inner gates; and
second nitrogen build-up areas extending along boundaries between the second source/drain patterns and the second inner spacers, and along boundaries between the second inner gates and the second sheet patterns.

9. The semiconductor device of claim 1, further comprising:
a second active pattern comprising a second lower pattern and second sheet patterns spaced apart from the second lower pattern in the first direction;
a second gate structure comprising second inner gates between the second lower pattern and a lowermost second sheet pattern of the second sheet patterns, and between each pair of adjacent second sheet patterns; and
second source/drain patterns on the second lower pattern and connected to the second sheet patterns,
wherein the second source/drain patterns contact the second inner gates.

10. A semiconductor device comprising:
a first active pattern comprising a first lower pattern and first sheet patterns spaced apart from the first lower pattern in a first direction;
a first gate structure comprising first inner gates between the first lower pattern and a lowermost first sheet pattern of the first sheet patterns, and between each pair of adjacent first sheet patterns, the first inner gates extending in a second direction that intersects the first direction, wherein each of the first inner gates comprises a first gate electrode and a first gate insulating film;
first source/drain patterns on the first lower pattern, comprising doped n-type impurities, and connected to the first sheet patterns;
first inner spacers between the first source/drain patterns and the first inner gates; and
first nitrogen build-up areas extending along boundaries between the first source/drain patterns and the first inner spacers, and along boundaries between the first inner gates and the first sheet patterns.

11. The semiconductor device of claim 10, further comprising:
second nitrogen build-up areas within the first inner spacers,
wherein the first nitrogen build-up areas that extend along the boundaries between the first source/drain patterns and the first inner spacers are spaced apart from the second nitrogen build-up areas in a third direction that intersects the first direction and the second direction.

12. The semiconductor device of claim 10, further comprising:
a second active pattern comprising a second lower pattern and second sheet patterns spaced apart from the second lower pattern in the first direction;
a second gate structure comprising second inner gates between the second lower pattern and a lowermost second sheet pattern of the second sheet patterns, and between each pair of adjacent second sheet patterns;
second source/drain patterns on the second lower pattern, comprising doped p-type impurities, and connected to the second sheet patterns; and
second inner spacers between the second source/drain patterns and the second inner gates,
wherein no nitrogen build-up areas are formed along circumferences of the second inner gates.

13. The semiconductor device of claim 10, further comprising:
a second active pattern comprising a second lower pattern and second sheet patterns spaced apart from the second lower pattern in the first direction;
a second gate structure comprising second inner gates between the second lower pattern and a lowermost second sheet pattern of the second sheet patterns, and between each pair of adjacent second sheet patterns;
second source/drain patterns on the second lower pattern, comprising doped p-type impurities, and connected to the second sheet patterns;
second inner spacers between the second source/drain patterns and the second inner gates; and
second nitrogen build-up areas within the second inner spacers and extending along sidewalls of the second inner gates.

14. The semiconductor device of claim 13, further comprising:
third nitrogen build-up areas extending along boundaries between the second inner spacers and the second source/drain patterns.

15. A semiconductor device comprising:
a first active pattern comprising a first lower pattern and first sheet patterns spaced apart from the first lower pattern in a first direction;
a first gate structure comprising first inner gates between the first lower pattern and a lowermost first sheet pattern of the first sheet patterns, and between each pair of adjacent first sheet patterns, the first inner gates extending in a second direction that intersects the first direction, wherein each of the first inner gates comprises a first gate electrode and a first gate insulating film;
first source/drain patterns on the first lower pattern and connected to the first sheet patterns;
first inner spacers between the first source/drain patterns and the first inner gates;
a second active pattern comprising a second lower pattern and second sheet patterns spaced apart from the second lower pattern in the first direction;
a second gate structure comprising second inner gates between the second lower pattern and a lowermost second sheet pattern of the second sheet patterns, and between each pair of adjacent second sheet patterns, the second inner gates extending in the second direction;
second source/drain patterns on the second lower pattern and connected to the second sheet patterns;
second inner spacers between the second source/drain patterns and the second inner gates;
first nitrogen build-up areas within the first inner spacers; and
second nitrogen build-up areas within the second inner spacers,
wherein, in a third direction that intersects the first direction and the second direction a length of at least one of the first sheet patterns having a first height is greater than a length of at least one of the second sheet patterns having the first height.
